(19) Europäisches Patentamt / European Patent Office / Office européen des brevets

(11) **EP 3 594 709 A1**

(12) **EUROPEAN PATENT APPLICATION**
published in accordance with Art. 153(4) EPC

(43) Date of publication:
**15.01.2020 Bulletin 2020/03**

(51) Int Cl.:
*G01R 33/46* (2006.01)  *G01R 33/48* (2006.01)
*G01R 33/56* (2006.01)  *G01N 21/35* (2014.01)

(21) Application number: **18863033.9**

(22) Date of filing: **12.02.2018**

(86) International application number:
**PCT/CN2018/076387**

(87) International publication number:
**WO 2019/061995 (04.04.2019 Gazette 2019/14)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD TN**

(30) Priority: **29.09.2017 CN 201710910214**
**29.09.2017 CN 201710908925**
**29.09.2017 CN 201710908949**

(71) Applicant: **Fu Jian Jia Pu Xin Ke Technology Co., Ltd.**
**Fuzhou, Fujian 350012 (CN)**

(72) Inventor: **CHEN, Shuping**
**Richmond Hill, Ontario L4B 3V6 (CA)**

(74) Representative: **Berkkam, Ayfer**
**Berkkam Patent Consulting**
**Büklüm Sokak, No. 5/16-3**
**06680 Kavaklidere Ankara (TR)**

(54) **SUPERPOSITION FOURIER TRANSFORM-BASED SPECTROSCOPY AND IMAGING METHOD**

(57)    A superimpose Fourier Transform method applied to spectroscopy and imaging is provided in this invention. Raw signals are acquired by various spectrometric detectors. The acquired data are processed by Fourier Transform with a superimposed function to superimpose the transformed peak shapes. Then the superimposed signals are used to construct final spectral/imaging results. The superimpose Fourier Transform method in this invention applied to spectroscopy and imaging can narrow Fourier transformed peak width by half and bring about double of peak intensity. It is equivalent to produce the same effects by doubling optical path length of an interferometer or increasing doubly strength of a static magnet; alternatively, reduce half of sampling time for the same resolution on a same instrument.

Figure 1

**Description**

**RELATED APPLICATION PRIORITY**

This application claims priority to Patent Application Ser. No.201710908925.X, No.201710910214.6, No.201710908949.5 filed in China on Sep. 29,2017.

**TECHNICAL FIELD**

The present invention relates to mathematical transformation, signal processing, infrared spectroscopy, nuclear magnetic resonance spectroscopy and magnetic resonance imaging, particularly a spectroscopic and imaging method based on superimpose Fourier Transform.

Mathematical transformation has been widely used in signal processing, spectroscopic analysis and digital imaging. All of these applied techniques constantly make efforts how to improve signal resolution, reduce signal noise and accelerate the signal data acquisition and transportation. Due to rapid development in modern computer equipment, the data acquisition, storage, operation and display substantially are not confinement factors in application of mathematical transformation.

France mathematician and physicist Joseph Fourier as a precursor in 1807 first proved that any signal varied with time periodically can be expanded in cosine and sine series of trigonometric frequency functions as long as it satisfies convergence conditions. When period of a signal goes to infinite, the series converts to Fourier Transform, a well-known transformation technology. Integral form of Fourier Transform can be represented by discrete Fourier Transform to N of finite-duration trigonometric functions.

A signal function varied with time t with an inherent frequency $\omega_0$ can be described as $\cos(\omega_0 t) + i \sin(\omega_0 t)$, where $i = \sqrt{-1}$, and its Fourier Transform is:

$$\int_{-\infty}^{\infty} [\cos(\omega_0 t) + i \sin(\omega_0 t)] \, e^{-i\omega t} \, dt .$$

Applying Euler formula $e^{-i\omega t} = \cos(\omega t) - i\sin(\omega t)$, the Fourier Transform can be written as

$$\int_{-\infty}^{\infty} [\cos(\omega_0 t) + i \sin(\omega_0 t)] \, [\cos(\omega t) - i\sin(\omega t)] \, dt$$

The practical signals are always analyzed in finite time domain. Current Fourier Transform conducted three basic peak shapes illuminated in Table 1 specified as absorption peak shape, dispersion peak shape and magnitude peak shape. These three Fourier Transform peak shapes will directly or indirectly affect resolution in the signal analysis.

Table 1

| Peak Shape | Fourier integral | Frequency domain peak |
|---|---|---|
| Absorption | Real channel $$A_{\mathrm{real}} = \int \cos(\omega_0 t)\cos(\omega t)\,dt$$ Imaginary channel $$A_{\mathrm{imaginary}} = \int \sin(\omega_0 t)\sin(\omega t)\,dt$$ | |
| Dispersion | Real channel $$B_{\mathrm{real}} = \int \cos(\omega_0 t)\cos(\omega t)\,dt$$ Imaginary channel $$B_{\mathrm{imaginary}} = \int \sin(\omega_0 t)\cos(\omega t)\,dt$$ | |
| Magnitude | $$C = \sqrt{A^2 + B^2}$$ $A = A_{\mathrm{real}} + A_{\mathrm{imaginary}}$ $B = B_{\mathrm{real}} - B_{\mathrm{imaginary}}$ | |

Fourier Transform infrared spectrometry is originated from principle of the light wave coherence. Michelson interferometer can proportionally reduce frequency scope of infrared spectroscopy and so convenience to convert the acquired interferogram to infrared spectrum by Fourier Transform with a computer. Since the magnitude peak shape is mainly used in Fourier Transform infrared spectroscopy, the phase shift in the infrared frequency signal has little effect to the transform peak shape and no necessary to calibrate the phase shift of infrared signal. The greatest advantage of current Fourier Transform is that no causality calculation is required to the signals, in other words, we do not need forecast any parameter related to the signal except for the phase shift. Because our new technique added a superimpose step, the superimpose operation may ask to preset a few of signal parameters. Therefore, the original causality relationship is broken and also the preset parameter will take some more time in operation of Fourier Transform.

Current theory of Fourier Transform infrared spectrometry specified that its spectral resolution depends on optical path distance (maximum retardation) which is reciprocal to the distance. If we want the resolution to be increased doubly, that is, reduce peak width by half, the optical moving path of an interferometer should be double of the original one. This means that manufacturing cost and technical requirement have to be devoted with more than double; the equipment size will become bulky and heavy. And, most of infrared spectroscopic noises are random. Although infrared signal intensity (commonly named as signal-to-noise-ratio) can be enhanced by averaging of accumulation though multiplexed measurements, this method demands more storage space and operation time of a computer.

Nuclear magnetic resonance is one of the greatest inventions in twentieth century and profoundly improved our understanding and cognition to microscopic world. As a modern high technology it is not only a powerful tool to study quantum physics and chemical structures, also widely applied to biology, physiology, medicine, material science and geology, etc. Mechanism of nuclear magnetic resonance spectroscopy was originated from that nuclei with spin magnetic moment in a magnetic field can absorb energy of pulse radio-frequency radiation and produce resonance radio-frequency signal. The nuclei have different spin orientations in accordance with intrinsic quantum numbers of their spins, and distribute randomly under normal circumstance. Therefore, they do not appear energy difference. When these nuclei are placed in a magnetic field, they arrange regularly with their respective spin orientations and then demonstrate the energy difference. This phenomenon is famous Zeeman Effect in physics. The energy difference of the nuclear spins between high energy state and low energy state is:

$$\Delta E = \gamma \frac{h}{2\pi} B_0 \quad \text{(Zeeman Effect equation)}$$

where $\gamma$ is gyromagnetic ratio of a nucleus, $h$ is Plank's constant and $B_0$ is strength of an external magnetic field.

According to Boltzmann distribution of the energy system in thermal equilibrium, number of the nuclei in lower energy level is narrow majority relative to number of the nuclei in upper energy level. The narrow majority is approximately proportional to the magnetic field strength. When exerting an electric pulse of radio-frequency to the nuclei in a magnetic field, the nuclei in the lower energy level will transit to the upper energy level upon absorbed the radio-frequency corresponding to their spin precession, which is called response of nuclear magnetic resonance. After the pulse is over, the nuclei transited to the upper energy level return to the lower energy level due to relaxation effect and produce free induction decay signal with time duration. The detected free induction decay signal is converted to its nuclear magnetic resonance spectrum by Fourier Transform.

Resolution of nuclear magnetic resonance spectroscopy largely depends on the detected free induction decay signal, in other words, sampling time. When doubling strength of a static magnetic field, spin resonance frequency of a nucleus is also doubled according to its gyromagnetic ratio. Because measuring error of nuclear magnetic resonance frequency is determined by Heisenberg uncertainty principle, there is 2-fold of relative decrease in the frequency measuring error for the same measuring time. It also leads to double the signal intensity of nuclear magnetic resonance according to Boltzmann distribution theory. Moreover, an increase of the magnetic field strength is not just for speeding up nuclear spin precession frequency and raising signal intensity of nuclear magnetic resonance, it also increases energy difference between the upper and lower levels as the above Zeeman Effect equation, which is for more details to detect magnetic resonance interactions of the nucleus under various chemical environments.

It is a common configuration in modern nuclear magnetic resonance spectrometers to have two detectors assembled in orthogonal position, which is termed as dual channels. The free induction decay response actually is a complex signal composed of a real channel and an imaginary channel. Advantage of the dual channels relative to a single channel is peak intensity of nuclear magnetic resonance can be double, but the peak width keeps the same.

We already know that resolution of Fourier Transform nuclear magnetic resonance spectroscopy is proportional to strength of the principal static magnetic field. Although the resolution can be synchronously enhanced with raise of the magnetic field strength, it will lead the manufacturing cost and technical requirement to be more than double; the equipment size will become bulky and heavy, such as the largest superconductive static magnetic field with strength of 24 Teslas, height to 5 meters and weight to 15 tons. The peak width of nuclear magnetic resonance spectroscopy could be narrowed by longer sampling time, but the free induction decay signal will soon decline to zero due to the relaxation effect of nuclear magnetic resonance and circumstances around the nuclei. No matter how long the sampling time when it surpasses the zero decay point, the resolution would not be improved virtually.

Magnetic resonance imaging is an extensively used technique in medical imaging. Base on the principle that the nuclei with spins can absorb external pulse radio-frequency energy and produce resonance radio-frequency signals when they are placed in a static magnetic field. After adding a three-dimensional gradient magnetic field on the principal static magnetic field, spatial distribution of the resonance radio-frequency signals is obtained. Water and fat are major compositions of human body and biological tissues. Magnetic resonance imaging mainly is used to detect proton magnetic resonance signals of hydrogen nucleus, termed as proton density image of the tissues.

The nuclei with spins have a very important characteristic constant - gyromagnetic ratio, resonance precession frequency of the nuclei corresponding to magnetic field strength. Gyromagnetic ratio of proton = 42.58 MHz/tesla. Spin precession frequency of proton is 63.87 MHz in a magnetic field of 1.5 teslas and 127.74 MHz as magnetic field strength is increased to 3 teslas.

Procedure to perform magnetic resonance imaging is: first to set magnetic gradient following the principal static magnetic field on sectional plane of a human body; by applying a radio-frequency pulse to choose the body section to be scanned for imaging; then on orthogonal plane to the section, along vertical-axis for phase scan and along horizontal-axis for frequency scan to acquire planar gradient encoding resonance signals, termed as $k$-space. These codes are composed of a raw data matrix by filling the magnetic gradient response signals as scheduled trajectory direction. The phase gradient along vertical-axis varies regularly over time and thus is equivalent to the frequency scan substantially. The detected raw data in the $k$-space are converted to magnetic resonance image by Fourier Transform.

Resolution of magnetic resonance imaging very depends on the sampling time and signal-to-noise-ratio. When doubling strength of a static magnetic field, spin resonance frequency of a nucleus is also doubled according to its gyromagnetic ratio. Because measuring error of nuclear magnetic resonance frequency is determined by Heisenberg uncertainty principle, there is 2-fold of relative decrease in the frequency measuring error for the same measuring time. It also leads to double the signal intensity of nuclear magnetic resonance according to Boltzmann distribution theory. Therefore, an increase of the magnetic field strength not only speeds up nuclear spin precession frequency and also raising signal intensity of nuclear magnetic resonance; consequently increases spatial resolution of magnetic resonance imaging. The spatial resolution of modern magnetic resonance imaging instruments at present is enhanced by increase of the magnetic field.

Nuclear magnetic resonance imaging is a very advanced medical examination tool. In order to study pathological mechanism, various experimental pulse sequences have been designed to detect proton resonance response in the bioactive tissues, to probe proton density of water molecules or fats; such as longitudinal relaxation imaging and transverse relaxation imaging, etc. Magnetic resonance imaging as a high technology requires operating and controlling many technical parameters to obtain high quality of the tissue images. Nevertheless, the raw data collected in a $k$-space have to be converted to an image by Fourier Transform eventually.

Gradient magnetic resonance response is a complex signal composed of real channel readout and imaginary channel readout from dual channel detectors equipped in magnetic resonance imaging apparatus.

A single pixel area $\Delta x \Delta y$ (in $x$-$y$ plane of Descartes coordinates) of proton resonance response in gradient magnetic fields can calculated from below equations as absorption peak shape of Fourier Transform:

$$\Delta x = \frac{2\pi}{\gamma G_x T_x}; \Delta y = \frac{2\pi}{\gamma G_y T_y} \ ,$$

where $\gamma$ is gyromagnetic ratio of a nucleus; $G_x$ and $G_y$ are magnetic field gradients; $T_x$ and $T_y$ are full sampling times along $x$- and $y$- directions.

The spatial resolution of Fourier Transform magnetic resonance imaging apparatus is proportional to strength of the principal static magnetic field as above illustrations. Although the spatial resolution can be synchronously enhanced with the magnetic field strength, it will lead the manufacturing cost and technical requirement to be more than double; the equipment size will become bulky and heavy. Considering that electromagnetic radiation may have biological effect to human health. International medical authorizations confined that not more than 3 teslas of magnetic field strength should be employed in clinical applications. The magnetic resonance pixel can be shrunken by extending the sampling time (or increase of the gradient slope) according to the above imaging pixel equation. However, if the pixel area is small over detection tolerability, its signal-to-noise-ratio will be seriously declined, instead of to seriously reduce the spatial resolution.

## SUMMARY OF THE INVENTION

Purpose of this invention is to provide a superimpose Fourier Transform method applied to spectroscopy and imaging to overcome the fundamental limitations in the current technologies.

To achieve this goal our technical proposal is: a superimpose Fourier Transform method applied to spectroscopy and imaging was characterized to acquire raw signal from the relevant instruments, use Fourier Transform with a superimpose function to implement superimposed peak shape and to constitute the spectrum or image after the signal is processed by the superimposed peak shape.

Further, it includes a Fourier Transform Infrared Spectroscopy can be obtained by superimposed peak shape in Fourier Transform. Infrared light generated from an infrared laser source passes an interferometer, sample chamber. The resulted infrared interferogram is measured on an infrared detector. Its infrared interferogram is sampling by a computer unit. Perform superimposed Fourier Transform to the sampled interferogram by the superimposing functions for individual infrared peaks to obtain infrared percentage transmittance and processed infrared spectrum is shown by a display unit.

In an embodiment of this invention, a sampled infrared interferogram signal is basically to be:

$$f(t) = 2\pi K \cos(\omega_0 t) \qquad 0 \le t \le T,$$

where $K$ is intensity of a signal, $T$ is sampling period for a cosine signal $K\cos(\omega_0 t)$ with frequency $\omega_0$.

Its basic absorption peak shape after Fourier Transform for the infrared interferogram signal is:

$$A(\omega) = K \frac{\sin[(\omega - \omega_0)T]}{\omega - \omega_0}.$$

As an infrared signal contains N of frequencies, the angular frequencies are expressed as series $\omega = 2m\pi/T$ and $\omega_0 = 2n\pi/T$, where m and n = 0, 1, 2, ... ..., N-1, its corresponding discrete absorption peak shape is:

$$A(\omega) = KT \left\{ \frac{\sin[2\pi(m-n)]}{2\pi(m-n)} \right\}.$$

The basic dispersion peak shape of Fourier Transform is:

$$B(\omega) = K \frac{1 - \cos[(\omega - \omega_0)T]}{\omega - \omega_0} = KT \frac{\sin^2[(\omega - \omega_0)T/2]}{(\omega - \omega_0)T/2};$$

Its discrete dispersion peak shape is:

$$B(\omega) = KT \left\{ \frac{\sin^2[\pi(m-n)]}{\pi(m-n)} \right\}.$$

The basic magnitude peak shape of Fourier Transform is:

$$C(\omega) = \sqrt{[A(\omega)]^2 + [B(\omega)]^2} = K \left| \frac{2\sin[(\omega - \omega_0)T/2]}{\omega - \omega_0} \right|.$$

Its discrete magnitude peak shape is:

$$C(\omega) = KT \left| \frac{\sin[\pi(m-n)]}{\pi(m-n)} \right|.$$

Define superimpose functions as below:

$$\text{Simp}_1(x) = 1 + \frac{x}{|x|} = \begin{cases} 0 & x < 0 \\ 2 & x \ge 0 \end{cases}$$

$$\text{Simp}_2(x) = 1 - \frac{x}{|x|} = \begin{cases} 2 & x < 0 \\ 0 & x \geq 0 \end{cases}.$$

Dedicate the superimpose function $\text{Simp}_1$ with plus sign as right-side superimpose function and the one with minus sign as left-side superimpose function; It has the same superimpose effect to replace $x/|x|$ with $|x|/x$ in the two superimpose functions.

With substituting the independent variable $x = \omega - \omega_0$ in the superimpose functions, the above infrared interferogram signal is superimposed by the superimpose functions.

Absorption peak shape via the superimposed Fourier Transform is:

$$A'(\omega) = K \left\{ \frac{\sin[(\omega - \omega_0)T]}{\omega - \omega_0} \pm \frac{\sin[(\omega - \omega_0)T]}{|\omega - \omega_0|} \right\}$$

$$= \left(1 \pm \frac{\omega - \omega_0}{|\omega - \omega_0|}\right) A(\omega) ;$$

Its corresponding discrete absorption peak shape is:

$$A'(\omega) = \left(1 \pm \frac{m - n}{|m - n|}\right) KT \left\{ \frac{\sin[2\pi(m - n)]}{2\pi(m - n)} \right\}.$$

Dispersion peak shape via the superimpose Fourier Transform is:

$$B'(\omega) = \left(1 \pm \frac{\omega - \omega_0}{|\omega - \omega_0|}\right) B(\omega) ;$$

Its corresponding discrete dispersion peak shape is:

$$B'(\omega) = \left(1 \pm \frac{m - n}{|m - n|}\right) KT \left\{ \frac{\sin^2[\pi(m - n)]}{\pi(m - n)} \right\}.$$

Magnitude peak shape via the superimpose Fourier Transform is:

$$C'(\omega) = \left(1 \pm \frac{\omega - \omega_0}{|\omega - \omega_0|}\right) C(\omega) ;$$

Its corresponding discrete magnitude peak shape is:

$$C'(\omega) = \left(1 \pm \frac{m - n}{|m - n|}\right) KT \left| \frac{\sin[\pi(m - n)]}{\pi(m - n)} \right|.$$

In this embodiment of the invention, wherein said the superimposed peak shapes should also include: After the infrared interferogram is acquired completely, reconstitute spectral peaks with regard to individual symmetric axes and peak widths at base. Apply phase correction and Gibbs apodization function to them, use deconvolution algorithm for the absorption, dispersion or magnitude peak shapes of the Fourier Transform, and perform peak superimpose with the superimpose functions.

In this embodiment of the invention, wherein said the superimposed peak shape should further include: Select appropriate sampling points and resolution to group sample frequencies $\omega_0$, perform peak superimpose with the superimpose functions for the absorption, dispersion or magnitude peak shapes of the Fourier Transform in each group.

In this embodiment of the invention, wherein said the superimposed peak shape should further include: The infrared interferogram $f(t)$ is discretized and digitally sampled. If there are $N$ of samples, it should have a set of discrete signal points $f(0)$, $f(1)$, $f(2)$, $\cdots$, $f(k)$, $\cdots$, $f(N\text{-}1)$. $N$ of the data $F(0)$, $F(1)$, $F(2)$, $\cdots F(k)$, $\cdots$, $F(N\text{-}1)$ are acquired by discrete Fourier Transform to get following Fourier Transform matrix:

$$\begin{pmatrix} F(0) \\ F(1) \\ F(2) \\ \vdots \\ F(k) \\ \vdots \\ F(N-1) \end{pmatrix} = \begin{pmatrix} 1 & 1 & 1 & \cdots & 1 \\ 1 & W & W^2 & \cdots & W^{N-1} \\ 1 & W^2 & W^4 & \cdots & W^{N-2} \\ \vdots & \vdots & \vdots & \ddots & \vdots \\ 1 & W^k & W^{2k} & \cdots & W^{N-k} \\ \vdots & \vdots & \vdots & \ddots & \vdots \\ 1 & W^{N-1} & W^{N-2} & \cdots & W \end{pmatrix} \begin{pmatrix} f(0) \\ f(1) \\ f(2) \\ \vdots \\ f(k) \\ \vdots \\ f(N-1) \end{pmatrix},$$

where the factor $W = exp(\text{-}i2\pi/N)$ in the $N \times N$ of Fourier Transform matrix.

By inserting a specific diagonal superimpose matrix in above formula, a superimpose Fourier Transform matrix is obtained for superimpose operation:

$$\begin{pmatrix} F(0) \\ F(1) \\ F(2) \\ \vdots \\ F(k) \\ \vdots \\ F(N-1) \end{pmatrix} = \begin{pmatrix} 1 & 1 & 1 & 1 & \cdots & 1 \\ 1 & W & W^2 & W^3 & \cdots & W^{N-1} \\ 1 & W^2 & W^4 & W^6 & \cdots & W^{N-2} \\ \vdots & \vdots & \vdots & \vdots & \ddots & \vdots \\ 1 & W^k & W^{2k} & W^{3k} & \cdots & W^{N-k} \\ \vdots & \vdots & \vdots & \vdots & \ddots & \vdots \\ 1 & W^{N-1} & W^{N-2} & W^{N-3} & \cdots & W \end{pmatrix} \begin{pmatrix} 2(0) & 0 & 0 & 0 & \cdots & 0 \\ 0 & 2(0) & 0 & 0 & \cdots & 0 \\ 0 & 0 & 2(0) & 0 & \cdots & 0 \\ \vdots & \vdots & \vdots & \vdots & \ddots & \vdots \\ 0 & 0 & 0 & 0 & \cdots & 0 \\ \vdots & \vdots & \vdots & \vdots & \ddots & \vdots \\ 0 & 0 & 0 & 0 & \cdots & 2(0) \end{pmatrix} \begin{pmatrix} f(0) \\ f(1) \\ f(2) \\ \vdots \\ f(k) \\ \vdots \\ f(N-1) \end{pmatrix}.$$

In this embodiment of the invention, wherein said to scan row-to-row, or $\Delta N$-row-to $\Delta N$-row for a desired resolution $\Delta N$. The corresponding slop variation is compared to determine the diagonal elements of the inserted matrix to be 2 or 0.

In this embodiment of the invention, wherein said to take value of 2 for the diagonal matrix element when the slope of front point is positive in right-superimpose operation; to take value of 0 for the diagonal matrix element as slope of the front point is negative or 0. It is opposite in left-superimpose operation.

In this embodiment of the invention, wherein said to take the diagonal matrix element to be 2 or 0 relying on whether each peak value is increase, steady or decrease by comparing with scanned front point.

In this embodiment of the invention, wherein said the superimposed peak shape should further include: adjacent harmonic signals can be superimposed for the front peak by left or right superimpose and for the back peak by right or left superimpose synchronously.

In this embodiment of the invention, wherein said to use Helium-Neon laser with emitting wavelength 632.8nm as infrared light source. The interferometer in the embodiment was double-sided optical path with 3295 of retardation steps, resolution of 16cm$^{-1}$, and 709 of wavenumber readings as 3.85cm$^{-1}$ of interval displacement.

In this embodiment of the invention, wherein said to use thermal radiation, gaseous charge and laser infrared light sources with wavelength range from 0.78nm to 1000nm. Arms of the interferometer move in back and forth directions, and can be designed to high resolution scope of 4cm$^{-1}$ to 0.07cm$^{-1}$.

In this embodiment of the invention, wherein is applicable to acquire infrared transmittance of Raman spectrometry, near infrared spectrometry and far infrared spectrometry.

In this embodiment of the invention, wherein included to handle free induction decay and phase shift in signal frequencies.

Further, the invention further includes nuclear magnetic resonance spectrometry based on superimpose Fourier Transform to superimpose peak shape of nuclear magnetic resonance. It can be realized by following procedures:

Step S1: time domain signal of nuclear magnetic resonance is acquired from dual detection channels of a nuclear magnetic resonance apparatus;

Step S2: time domain signal of nuclear magnetic resonance acquired in step S1 is operated by Fourier Transform to get basic absorption, dispersion and magnitude peak shapes of Fourier Transform. They are sampling discretely to produce discrete basic absorption, dispersion and magnitude peak shapes, respectively;

Step S3: The peak shapes obtained in step S2 is superimposed through a suitable superimpose function to obtain superimposed absorption, dispersion and/or magnitude peak shapes of superimpose Fourier Transform. They are sampling discretely to produce discrete absorption, dispersion and magnitude superimposed peak shapes, respectively;

Step S4: A corresponding nuclear magnetic resonance spectrum is obtained from the above superimposed peak shapes.

In an embodiment of this invention, wherein said to use below superimpose functions in step S3:

$$\mathrm{Simp}_1(x) = 1 + \frac{x}{|x|} = \left\{ \begin{array}{ll} 0 & x < 0 \\ 2 & x \geq 0 \end{array} \right.$$

$$\mathrm{Simp}_2(x) = 1 - \frac{x}{|x|} = \left\{ \begin{array}{ll} 2 & x < 0 \\ 0 & x \geq 0 \end{array} \right. .$$

Dedicate the superimpose function $\mathrm{Simp}_1$ with plus sign as right-side superimpose function and the one with minus sign as left-side superimpose function; It has the same superimpose effect to replace $x/|x|$ with $|x|/x$ in the two superimpose functions.

In this embodiment of the invention, wherein said a time $t$ domain (0 to $T$) signal detected from dual detection channels of nuclear magnetic resonance spectrometer to be:

$$f(t) = 2\pi K\, e^{-t/\tau}\, [\cos(\omega_0 t) + i\, \sin(\omega_0 t)] \qquad 0 \leq t \leq T,$$

where $\omega_0$ is nuclear magnetic resonance frequency of a nucleus with intensity $K$ and free induction decay coefficient $\tau$.

The basic absorption peak shape of Fourier Transform in the above step 2 is:

$$A(\omega) = 2K \frac{\sin\left[(\omega - \omega_0)T\right]}{\omega - \omega_0} ;$$

For $N$ of composed nuclear spin frequencies, the angular frequencies are expressed by series $\omega = 2m\pi/T$ and $\omega_0 = 2n\pi/T$, where m and n = 0, 1, 2, $\cdots\cdots$, N-1, its discrete basic absorption peak shape is:

$$A(\omega) = 2KT \left\{ \frac{\sin\left[2\pi(m - n)\right]}{2\pi(m - n)} \right\} ;$$

With substituting the independent variance $x = \omega - \omega_0$ in the superimpose functions for the step 3 and superimposing the peak shape by the superimpose function, a superimposed absorption peak shape from the superimpose Fourier Transform is obtained:

$$A^{'}(\omega) = 2K\left\{\frac{\sin\left[(\omega - \omega_0)T\right]}{\omega - \omega_0} \pm \frac{\sin\left[(\omega - \omega_0)T\right]}{|\omega - \omega_0|}\right\}$$

$$= \left(1 \pm \frac{\omega - \omega_0}{|\omega - \omega_0|}\right) A(\omega)_{;}$$

A corresponding discrete superimposed absorption peak shape is:

$$A'(\omega) = 2\left(1 \pm \frac{m - n}{|m - n|}\right) KT\left\{\frac{\sin\left[2\pi(m - n)\right]}{2\pi(m - n)}\right\}_{.}$$

In this embodiment of the invention, wherein said by a time $t$ domain (0 to $T$) signal of nuclear magnetic resonance detected in dual channels to be:

$$f(t) = 2\pi K \, e^{-t/\tau} \left[\cos(\omega_0 t) + i \, \sin(\omega_0 t)\right] \qquad 0 \leq t \leq T,$$

where $\omega_0$ is nuclear magnetic resonance frequency of a nucleus with intensity $K$ and free induction decay coefficient $\tau$.
The basic dispersion peak shape of Fourier Transform in the above step S2 is:

$$B(\omega) = \pm 2K\frac{1 - \cos\left[(\omega - \omega_0)T\right]}{\omega - \omega_0} = \pm KT\frac{\sin^2\left[(\omega - \omega_0)T/2\right]}{(\omega - \omega_0)T/2}_{;}$$

The corresponding discrete basic dispersion peak shape is:

$$B(\omega) = \pm 2KT\left\{\frac{\sin^2\left[\pi(m - n)\right]}{\pi(m - n)}\right\}_{;}$$

With substituting the $x = \omega - \omega_0$ for the step 3 and superimposing the peak shape by the superimpose function, a superimposed dispersion peak shape from the superimpose Fourier Transform is obtained:

$$B'(\omega) = \left(1 \pm \frac{\omega - \omega_0}{|\omega - \omega_0|}\right) B(\omega)_{.}$$

A corresponding discrete superimposed dispersion peak shape is:

$$B'(\omega) = 2\left(1 \pm \frac{m - n}{|m - n|}\right) KT\left\{\frac{\sin^2\left[\pi(m - n)\right]}{\pi(m - n)}\right\}_{.}$$

In this embodiment of the invention, wherein said a time t domain (0 to $T$) signal of nuclear magnetic resonance detected in dual channels to be:

$$f(t) = 2\pi K \, e^{-t/\tau} \left[\cos(\omega_0 t) + i \, \sin(\omega_0 t)\right] \qquad 0 \leq t \leq T,$$

where $\omega_0$ is nuclear magnetic resonance frequency of a nucleus with intensity $K$ and free induction decay coefficient $\tau$.

The basic magnitude peak shape of Fourier Transform in the above step S2 is:

$$C(\omega) = \sqrt{[A(\omega)]^2 + [B(\omega)]^2} = 2K \left| \frac{2\sin[(\omega - \omega_0)T/2]}{\omega - \omega_0} \right|;$$

A corresponding discrete superimposed magnitude peak shape is:

$$C(\omega) = 2KT \left| \frac{\sin[\pi(m-n)]}{\pi(m-n)} \right|;$$

With substituting the $x = \omega - \omega_0$ for the step 3 and superimposing the peak shape by the superimpose function, a superimposed magnitude peak shape from the superimpose Fourier Transform is obtained:

$$C'(\omega) = \left(1 \pm \frac{\omega - \omega_0}{|\omega - \omega_0|}\right) C(\omega);$$

A corresponding discrete superimposed magnitude peak shape is:

$$C''(\omega) = 2\left(1 \pm \frac{m-n}{|m-n|}\right) KT \left| \frac{\sin[\pi(m-n)]}{\pi(m-n)} \right|.$$

In this embodiment of the invention, wherein said further to include in the above step S3: Select appropriate sampling points and resolution to group sample frequencies $\omega_0$ for the time domain signal of nuclear magnetic resonance, perform peak superimpose with the superimpose functions for the absorption, dispersion or magnitude peak shapes of the Fourier Transform in each group.

In this embodiment of the invention, wherein said further to include: The harmonic nuclear magnetic resonance time signal $f(t)$ is discretized and digitally sampled. If there are $N$ of samples, it should have a set of discrete signal points $f(0), f(1), f(2), \cdots, f(k), \cdots, f(N\text{-}1)$. $N$ of the data $F(0), F(1), F(2), \cdots F(k), \cdots, F(N\text{-}1)$ are acquired by discrete Fourier Transform to get a following Fourier Transform matrix:

$$\begin{pmatrix} F(0) \\ F(1) \\ F(2) \\ \vdots \\ F(k) \\ \vdots \\ F(N-1) \end{pmatrix} = \begin{pmatrix} 1 & 1 & 1 & \cdots & 1 \\ 1 & W & W^2 & \cdots & W^{N-1} \\ 1 & W^2 & W^4 & \cdots & W^{N-2} \\ \vdots & \vdots & \vdots & \ddots & \vdots \\ 1 & W^k & W^{2k} & \cdots & W^{N-k} \\ \vdots & \vdots & \vdots & \ddots & \vdots \\ 1 & W^{N-1} & W^{N-2} & \cdots & W \end{pmatrix} \begin{pmatrix} f(0) \\ f(1) \\ f(2) \\ \vdots \\ f(k) \\ \vdots \\ f(N-1) \end{pmatrix},$$

where the factor $W = exp(-i2\pi/N)$ in the $N \times N$ of Fourier Transform matrix.

By inserting a specific diagonal superimpose matrix in above formula, a superimpose Fourier Transform matrix is obtained for superimpose operation:

$$\begin{pmatrix} F(0) \\ F(1) \\ F(2) \\ \vdots \\ F(k) \\ \vdots \\ F(N-1) \end{pmatrix} = \begin{pmatrix} 1 & 1 & 1 & 1 & \dots & 1 \\ 1 & W & W^2 & W^3 & \dots & W^{N-1} \\ 1 & W^2 & W^4 & W^6 & \dots & W^{N-2} \\ \vdots & \vdots & \vdots & \vdots & \ddots & \vdots \\ 1 & W^k & W^{2k} & W^{3k} & \dots & W^{N-k} \\ \vdots & \vdots & \vdots & \vdots & \ddots & \vdots \\ 1 & W^{N-1} & W^{N-2} & W^{N-3} & \dots & W \end{pmatrix} \begin{pmatrix} 2(0) & 0 & 0 & 0 & \dots & 0 \\ 0 & 2(0) & 0 & 0 & \dots & 0 \\ 0 & 0 & 2(0) & 0 & \dots & 0 \\ \vdots & \vdots & \vdots & \vdots & \ddots & \vdots \\ 0 & 0 & 0 & 0 & \dots & 0 \\ \vdots & \vdots & \vdots & \vdots & \ddots & \vdots \\ 0 & 0 & 0 & 0 & \dots & 2(0) \end{pmatrix} \begin{pmatrix} f(0) \\ f(1) \\ f(2) \\ \vdots \\ f(k) \\ \vdots \\ f(N-1) \end{pmatrix}.$$

In this embodiment of the invention, wherein said to scan row-to-row, or $\Delta N$-row-to $\Delta N$-row for a desired resolution $\Delta N$. The corresponding slop variation is compared to determine the diagonal elements of the inserted matrix to be 2 or 0.

In this embodiment of the invention, wherein said to set sampling points according to computer binary system. Take arrangement mode of $2 \cdots 2$, $0 \cdots 0$, $2 \cdots 2$, $0 \cdots 0$, $\cdots\cdots$ in the diagonal matrix elements to execute left-superimpose operation of the peak shapes; take mode of $0 \cdots 0$, $2 \cdots 2$, $0 \cdots 0$, $2 \cdots 2$, $\cdots\cdots$ in the diagonal matrix elements to execute right-superimpose operation of the peak shapes.

In this embodiment of the invention, wherein said the superimposed peak shape should further include: adjacent harmonic signals can be superimposed for the front peak by left or right superimpose and for the back peak by right or left superimpose synchronously.

In this embodiment of the invention, wherein said to handle free induction decay and phase shift in signal frequencies.

Further, it includes a magnetic resonance imaging method based on superimpose Fourier Transform to superimpose peak shape of nuclear magnetic resonance. It can be realized by following procedures:

Step S1: magnetic resonance signal is acquired by a magnetic resonance imaging apparatus;

Step S2: magnetic resonance signal acquired in step S1 is applied by Fourier Transform to get basic absorption, dispersion and magnitude peak shapes of Fourier Transform. They are sampling discretely to produce discrete basic absorption, dispersion and magnitude peak shapes, respectively;

Step S3: The peak shapes obtained in step S2 is superimposed through a suitable superimpose function to obtain superimposed absorption, dispersion and/or magnitude peak shapes of superimpose Fourier Transform. They are sampling discretely to produce discrete absorption, dispersion and magnitude superimposed peak shapes, respectively;

Step S4: The resulting signals are superimposed to generate magnetic resonance images.

In an embodiment of this invention, wherein said the nuclear magnetic resonance gradient echo signal is of a general form $S(t) = I(t)+iQ(t)$, which is composed of real portion in-phase and imaginary portion at orthogonal out-phase detected from dual channels.

In this embodiment of the invention, wherein said according to symmetric property of Fourier Transform, the image process of the steps S2 and S3 is also applicable to perform inverse Fourier Transform for magnetic resonance imaging.

In this embodiment of the invention, wherein said to use below superimpose functions in step S3:

$$\mathrm{Simp}_1(x) = 1 + \frac{x}{|x|} = \begin{cases} 0 & x < 0 \\ 2 & x \geq 0 \end{cases}$$

$$\mathrm{Simp}_2(x) = 1 - \frac{x}{|x|} = \begin{cases} 2 & x < 0 \\ 0 & x \geq 0 \end{cases}.$$

Dedicate the superimpose function $\mathrm{Simp}_1$ with plus sign as right-side superimpose function and the one with minus sign as left-side superimpose function; It has the same superimpose effect to replace $x/|x|$ with $|x|/x$ in the two superimpose functions.

In this embodiment of the invention, wherein said to analyze a $k$-space signal (acquired time $t$ from 0 to $T$) in the above step S1:

$$f(t) = 2\pi K \left[\cos(\omega_0 t) + i \sin(\omega_0 t)\right] \qquad 0 \le t \le T,$$

where $\omega_0$ is nuclear magnetic resonance frequency of a nucleus with intensity $K$ and free induction decay coefficient $\tau$.

The basic absorption peak shape of Fourier Transform in the above step S2 is:

$$A(\omega) = K \frac{\sin\left[(\omega - \omega_0)T\right]}{\omega - \omega_0};$$

For $N$ of the $k$-space signals, the angular frequencies are expressed by series $\omega = 2m\pi/T$ and $\omega_0 = 2n\pi/T$, where m and n = n = 0, 1, 2, ⋯ ⋯, N-1, its discrete basic absorption peak shape is:

$$A(\omega) = KT \left\{ \frac{\sin\left[2\pi(m - n)\right]}{2\pi(m - n)} \right\};$$

With substituting the independent variance $x = \omega - \omega_0$ in the superimpose functions for the step 3 and superimposing the peak shape by the superimpose function, a superimposed absorption peak shape from the superimpose Fourier Transform is obtained:

$$A'(\omega) = K \left\{ \frac{\sin\left[(\omega - \omega_0)T\right]}{\omega - \omega_0} \pm \frac{\sin\left[(\omega - \omega_0)T\right]}{|\omega - \omega_0|} \right\}$$

$$= \left(1 \pm \frac{\omega - \omega_0}{|\omega - \omega_0|}\right) A(\omega).$$

The corresponding discrete superimposed absorption peak shape is:

$$A'(\omega) = \left(1 \pm \frac{m - n}{|m - n|}\right) KT \left\{ \frac{\sin\left[2\pi(m - n)\right]}{2\pi(m - n)} \right\}.$$

In this embodiment of the invention, wherein said to analyze a $k$-space signal (acquired time t from 0 to $T$) in the above step S1:

$$f(t) = 2\pi K \left[\cos(\omega_0 t) + i \sin(\omega_0 t)\right] \qquad 0 \le t \le T,$$

where $\omega_0$ is nuclear magnetic resonance frequency of a nucleus with intensity $K$ and free induction decay coefficient $\tau$.

The basic dispersion peak shape of Fourier Transform in the above step S2 is:

$$B(\omega) = K \frac{1 - \cos\left[(\omega - \omega_0)T\right]}{\omega - \omega_0} = KT \frac{\sin^2\left[(\omega - \omega_0)T/2\right]}{(\omega - \omega_0)T/2};$$

The corresponding discrete dispersion peak shape is:

$$B(\omega) = KT\left\{\frac{\sin^2[\pi(m-n)]}{\pi(m-n)}\right\};$$

With substituting $x = \omega - \omega_0$ and superimposing the peak shape by the superimpose function for the above step S3, a superimposed dispersion peak shape from the superimpose Fourier Transform is obtained:

$$B'(\omega) = \left(1 \pm \frac{\omega - \omega_0}{|\omega - \omega_0|}\right) B(\omega);$$

The corresponding discrete superimposed dispersion peak shape is:

$$B'(\omega) = \left(1 \pm \frac{m-n}{|m-n|}\right) KT\left\{\frac{\sin^2[\pi(m-n)]}{\pi(m-n)}\right\}.$$

In this embodiment of the invention, wherein said to analyze a *k*-space signal (acquired time t from 0 to *T*) in the above step S1:

$$f(t) = 2\pi K\left[\cos(\omega_0 t) + i\,\sin(\omega_0 t)\right] \qquad 0 \le t \le T,$$

where $\omega_0$ is nuclear magnetic resonance frequency of a nucleus with intensity *K* and free induction decay coefficient $\tau$.
The basic magnitude peak shape of Fourier Transform in above step S2 is:

$$C(\omega) = \sqrt{[A(\omega)]^2 + [B(\omega)]^2} = K\left|\frac{2\sin[(\omega - \omega_0)T/2]}{\omega - \omega_0}\right|$$

Corresponding discrete superimposed magnitude peak shape is:

$$C(\omega) = KT\left|\frac{\sin[\pi(m-n)]}{\pi(m-n)}\right|.$$

With substituting the independent variance $x = \omega - \omega_0$ in the superimpose functions for the step 3 and superimposing the peak shape by the superimpose function, a superimposed magnitude peak shape is obtained from the superimpose Fourier Transform:

$$C'(\omega) = \left(1 \pm \frac{\omega - \omega_0}{|\omega - \omega_0|}\right) C(\omega);$$

Corresponding discrete superimposed magnitude peak shape is:

$$C'(\omega) = \left(1 \pm \frac{m-n}{|m-n|}\right) KT\left|\frac{\sin[\pi(m-n)]}{\pi(m-n)}\right|.$$

In this embodiment of the invention, wherein said the superimposed peak shape should further include in the above step S3:
Select appropriate sampling points and resolution to group sample frequencies $\omega_0$ for the imaging signal of nuclear magnetic resonance, perform peak superimpose with the superimpose functions for the absorption, dispersion or magnitude peak shapes of the Fourier Transform in each group.

In this embodiment of the invention, wherein said the superimposed peak shape should further include: The harmonic nuclear magnetic resonance time signal $f(t)$ is discretized and digitally sampled. If there are $N$ of samples, it should have a set of discrete signal points $f(0)$, $f(1)$, $f(2)$, $\cdots$, $f(k)$, $\cdots$, $f(N-1)$. $N$ of the data $F(0)$, $F(1)$, $F(2)$, $\cdots F(k)$, $\cdots$, $F(N-1)$ are acquired by discrete Fourier Transform to get a following Fourier Transform matrix:

$$
\begin{pmatrix} F(0) \\ F(1) \\ F(2) \\ \vdots \\ F(k) \\ \vdots \\ F(N-1) \end{pmatrix} = \begin{pmatrix} 1 & 1 & 1 & \cdots & 1 \\ 1 & W & W^2 & \cdots & W^{N-1} \\ 1 & W^2 & W^4 & \cdots & W^{N-2} \\ \vdots & \vdots & \vdots & \ddots & \vdots \\ 1 & W^k & W^{2k} & \cdots & W^{N-k} \\ \vdots & \vdots & \vdots & \ddots & \vdots \\ 1 & W^{N-1} & W^{N-2} & \cdots & W \end{pmatrix} \begin{pmatrix} f(0) \\ f(1) \\ f(2) \\ \vdots \\ f(k) \\ \vdots \\ f(N-1) \end{pmatrix} .
$$

where the factor $W = exp(-i2\pi/N)$ in the $N \times N$ of Fourier Transform matrix.

By inserting a specific diagonal superimpose matrix in above formula, a superimpose Fourier Transform matrix is obtained for superimpose operation:

$$
\begin{pmatrix} F(0) \\ F(1) \\ F(2) \\ \vdots \\ F(k) \\ \vdots \\ F(N-1) \end{pmatrix} = \begin{pmatrix} 1 & 1 & 1 & 1 & \cdots & 1 \\ 1 & W & W^2 & W^3 & \cdots & W^{N-1} \\ 1 & W^2 & W^4 & W^6 & \cdots & W^{N-2} \\ \vdots & \vdots & \vdots & \vdots & \ddots & \vdots \\ 1 & W^k & W^{2k} & W^{3k} & \cdots & W^{N-k} \\ \vdots & \vdots & \vdots & \vdots & \ddots & \vdots \\ 1 & W^{N-1} & W^{N-2} & W^{N-3} & \cdots & W \end{pmatrix} \begin{pmatrix} 2(0) & 0 & 0 & 0 & \cdots & 0 \\ 0 & 2(0) & 0 & 0 & \cdots & 0 \\ 0 & 0 & 2(0) & 0 & \cdots & 0 \\ \vdots & \vdots & \vdots & \vdots & \ddots & \vdots \\ 0 & 0 & 0 & 0 & \cdots & 0 \\ \vdots & \vdots & \vdots & \vdots & \ddots & \vdots \\ 0 & 0 & 0 & 0 & \cdots & 2(0) \end{pmatrix} \begin{pmatrix} f(0) \\ f(1) \\ f(2) \\ \vdots \\ f(k) \\ \vdots \\ f(N-1) \end{pmatrix} .
$$

In this embodiment of the invention, wherein said value of 2 or 0 in the diagonal matrix elements to be determined as per row-to-row or desired resolution $\Delta N$ in the imaging region.

In this embodiment of the invention, wherein said to set sampling points according to computer binary system. Take arrangement mode of 2, 0, 2, 0, $\cdots\cdots$ in the diagonal matrix elements to execute left-superimpose operation of the peak shapes:

$$
\begin{pmatrix} 2 & 0 & 0 & 0 & 0 & \cdots & 0 \\ 0 & 0 & 0 & 0 & 0 & \cdots & 0 \\ 0 & 0 & 2 & 0 & 0 & \cdots & 0 \\ 0 & 0 & 0 & 0 & \vdots & \ddots & \vdots \\ 0 & 0 & 0 & 0 & 2 & \cdots & 0 \\ \vdots & \vdots & \vdots & \vdots & \vdots & \ddots & \vdots \\ 0 & 0 & 0 & 0 & 0 & \cdots & 0 \end{pmatrix} .
$$

Take arrangement mode of 0, 2, 0, 2, $\cdots\cdots$ in the diagonal matrix elements to execute right-superimpose operation of the peak shapes.

$$\begin{pmatrix} 0 & 0 & 0 & 0 & 0 & \cdots & 0 \\ 0 & 2 & 0 & 0 & 0 & \cdots & 0 \\ 0 & 0 & 0 & 0 & 0 & \cdots & 0 \\ 0 & 0 & 0 & 2 & \vdots & \ddots & \vdots \\ 0 & 0 & 0 & 0 & 0 & \cdots & 0 \\ \vdots & \vdots & \vdots & \vdots & \vdots & \ddots & \vdots \\ 0 & 0 & 0 & 0 & 0 & \cdots & 2 \end{pmatrix}.$$

In this embodiment of the invention, wherein said the superimposed peak shape should further include: adjacent harmonic signals can be superimposed for the front peak by left or right superimpose and for the back peak by right or left superimpose synchronously in the above step S3.

In this embodiment of the invention, wherein said to handle the signals with free induction decay and phase shift in signal frequencies. The free induction decay and phase shift are in exponential forms Therefore, these exponential components are actually equivalent to apodization functions multiplied to the signals. Their expressions of the corresponding peak shapes remain symmetric superimpose.

This invention has the following beneficial results relative to current technology:

(1) Unlike using a sophisticated and expensive instrument construction to improve performance, resolution and intensity of the signals are increased with 100% simply by the superimpose technique.

(2) The classical basic peak shapes (absorption, dispersion and magnitude) are superimposed with respective to their symmetry to narrow the peak widths of current Fourier Transform by half, double the signal intensity and resolution, and also reduce baseline noise effectively.

(3) The result utilized the method described in this invention is equivalent to raise the magnetic field strength doubly for the same sampling time, or achieve the same resolution by reducing half of the sampling time on an identical instrument.

(4) Adjacent harmonic signal peaks can be superimposed for the front peak by left- (or right-) superimpose and for the back peak by right- (or left-) superimpose synchronously, which could acquire four-times of the original resolution.

(5) The superimpose functions can be optimized to groups for superimpose of full or partial frequency components.

(6) This technique changes common concept of spectral peak shape, and invent a way of asymmetric peak shape. It ensures no information loss and raises quality of the signal analyses.

(7) It is applicable to those techniques based on the $k$-space, such as digital imaging, acoustic imaging (ultrasonic imaging and sonar imaging), and radar imaging, etc.

(8) It has the same effect to lengthen the optical path double in any infrared interferogram spectrometer.

(9) It is applicable to two-dimensional Fourier Transform nuclear magnetic resonance spectroscopy, and also those techniques which analyze free induction decay signals in time domain, such as Fourier Transform electron paramagnetic spectroscopy and Fourier Transform mass spectrometry, etc.

(10) The method initiated in this invention can be extensively applied to communication, spectroscopy and digital imaging, etc. Its features and advantages are strong applicability, low cost, high efficiency and ease operation.

## BRIEF DESCRIPTION OF THE DRAWINGS

FIG. **1** is a schematic drawing of Fourier Transform absorption peak shape in Example 1 of this invention.

FIG. **2** is a schematic drawing of Fourier Transform dispersion peak shape in Example 1 of this invention.

FIG **3** is a schematic drawing of Fourier Transform magnitude peak shape in Example 1 of this invention.

FIG **4** is a schematic drawing of left-superimpose Fourier Transform absorption peak shape in Example 1 of this invention.

FIG **5** is a schematic drawing of right-superimpose Fourier Transform absorption peak shape in Example 1 of this invention.

FIG. **6** is a schematic drawing of right-superimpose Fourier Transform dispersion peak shape in Example 1 of this invention.

FIG. **7** is a schematic drawing of right-superimpose Fourier Transform magnitude peak shape in Example 1 of this invention.

FIG. **8** is a schematic illustration of two partially overlapping peaks.

FIG. **9** is a schematic illustration of two infrared peaks separated by left-superimpose and comparing with their original merged peaks in Example 1 of this invention.

FIG. **10** is a schematic illustration of two infrared peaks separated by left-superimpose and right-superimpose, and comparing with their merged original peaks in Example 1 of this invention.

FIG. **11** is a diagram of raw infrared interferogram of background in Example 1 of this invention.

FIG. **12** is a diagram of raw infrared interferogram of polystyrene in Example 1 of this invention.

FIG. **13** is an infrared spectrum of polystyrene ranged from 470 to 3400 cm$^{-1}$ in Example 1 of this invention.

FIG. **14** is overlapping infrared spectra ranged from 2970 to 3200 cm$^{-1}$ in Example 1 of this invention, obtained by superimpose Fourier Transform and current Fourier Transform.

FIG. **15** is overlapping infrared spectra ranged from 1550 to 1650 cm$^{-1}$ in Example 1 of this invention, obtained by superimpose Fourier Transform and current Fourier Transform.

FIG. **16** is an infrared spectrum obtained by synchronously applying left-superimpose and right-superimpose regard to crucial wavenumbers between two adjacent peaks in FIG. **15** in Example 1 of this invention.

FIG. **17** is a schematic drawing of Fourier Transform absorption peak shape in Example 2 of this invention.

FIG. **18** is a schematic drawing of Fourier Transform dispersion peak shape in Example 2 of this invention.

FIG. **19** is a schematic drawing of Fourier Transform magnitude peak shape in Example 2 of this invention.

FIG. **20** is a schematic drawing of right-superimpose Fourier Transform absorption peak shape in Example 2 of this invention.

FIG. **21** is a schematic drawing of left-superimpose Fourier Transform absorption peak shape in Example 2 of this invention.

FIG. **22** is a schematic drawing of right-superimpose Fourier Transform dispersion peak shape in Example 2 of this invention.

FIG. **23** is a schematic drawing of right-superimpose Fourier Transform magnitude peak shape in Example 2 of this invention.

FIG. **24** is 300 MHz nuclear magnetic resonance free induction decay real channel signal of Ethylbenzene in Example 2 of this invention.

FIG. **25** is 300 MHz nuclear magnetic resonance free induction decay imaginary channel signal of Ethylbenzene in Example 2 of this invention.

FIG. **26** is nuclear magnetic resonance spectrum of Ethylbenzene by current Fourier Transform approach from the free induction decay signals shown in FIG. **24** and FIG. **25** in Example 2 of this invention.

FIG. **27** is nuclear magnetic resonance spectrum of Ethylbenzene by left-superimpose Fourier Transform from the free induction decay signals shown in FIG. **24** and FIG. **25** in Example 2 of this invention.

FIG. **28** is partially magnified segment of nuclear magnetic resonance spectrum in FIG. **27** with regard to hydrogen nuclei of the phenyl group in Ethylbenzene.

FIG. **29** is a comparison diagram between left-superimpose Fourier Transform and current Fourier Transform for the same free induction decay signals by sampling 4096 points in Example 2 of this invention.

FIG. **30** is a spin-spin coupled spectrum of 8 hydrogen nuclei of Ethylbenzene in Example 2 of this invention.

FIG. **31** is a schematic diagram by means of left-superimpose and right-superimpose synchronously for two adjacent peaks in Example 2 of this invention.

FIG. **32** is a schematic drawing of Fourier Transform absorption peak shape in Example 3 of this invention.

FIG. **33** is a schematic drawing of right-superimpose Fourier Transform absorption peak shape in Example 3 of this invention.

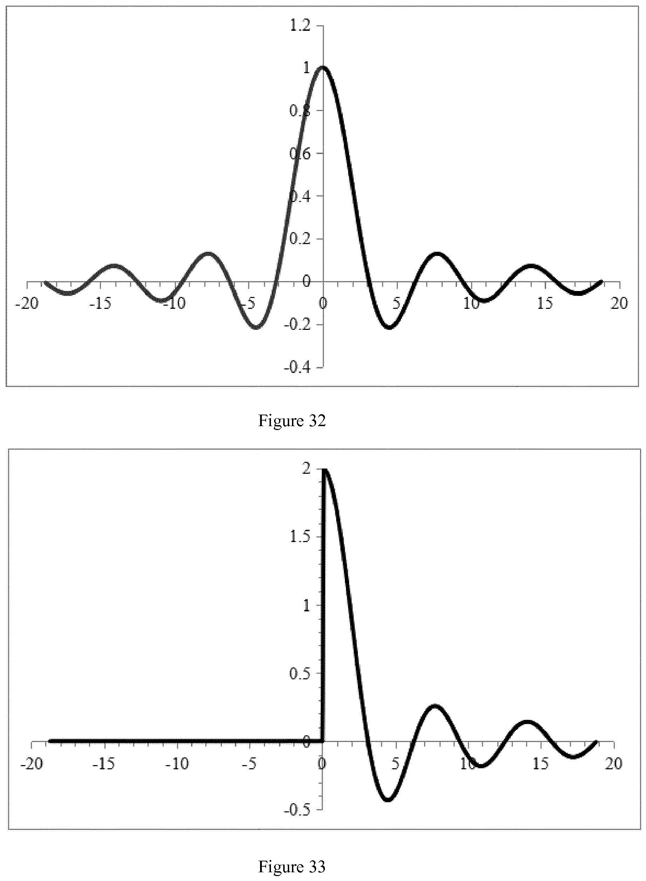

FIG. **33** is a schematic drawing of left-superimpose Fourier Transform absorption peak shape in Example 3 of this invention.

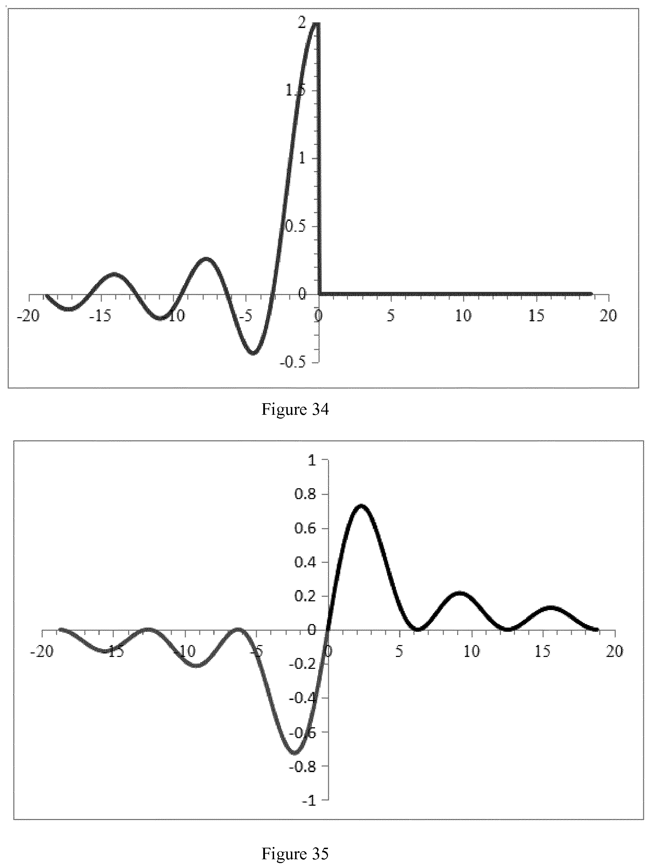

FIG. **35** is a schematic drawing of Fourier Transform dispersion peak shape in Example 3 of this invention.

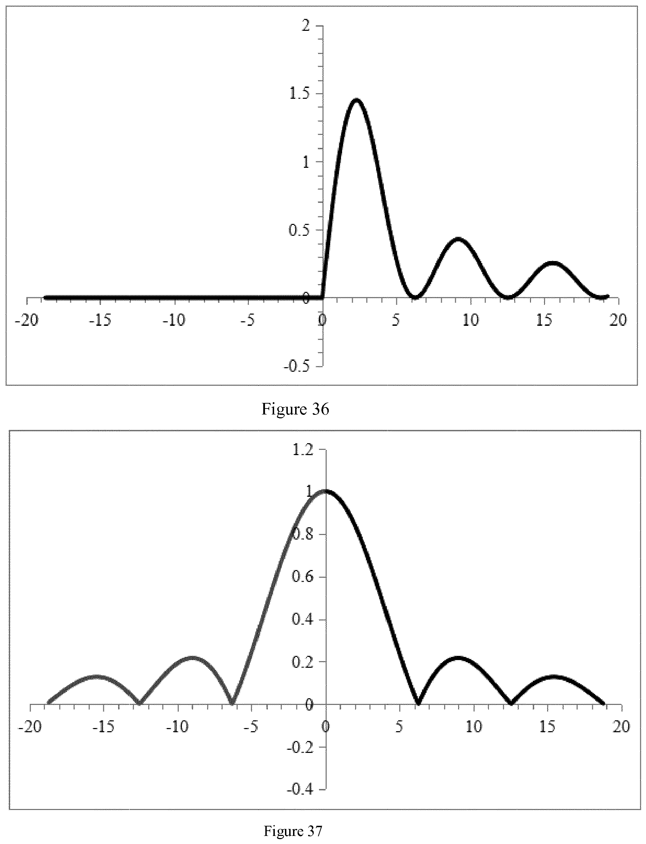

FIG. **36** is a schematic drawing of right-superimpose Fourier Transform dispersion peak shape in Example 3 of this invention.

FIG. **37** is a schematic drawing of Fourier Transform magnitude peak shape in Example 3 of this invention.

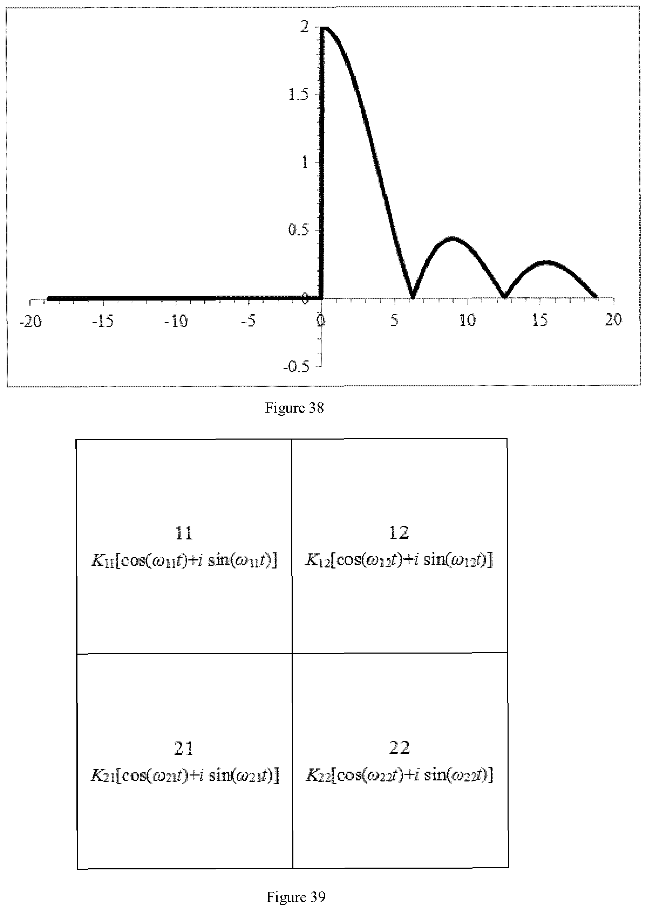

FIG. **38** is a schematic drawing of right-superimpose Fourier Transform magnitude peak shape in Example 3 of this invention.

FIG. **39** is a schematic pixel diagram of magnetic resonance imaging in Example 3 of this invention.

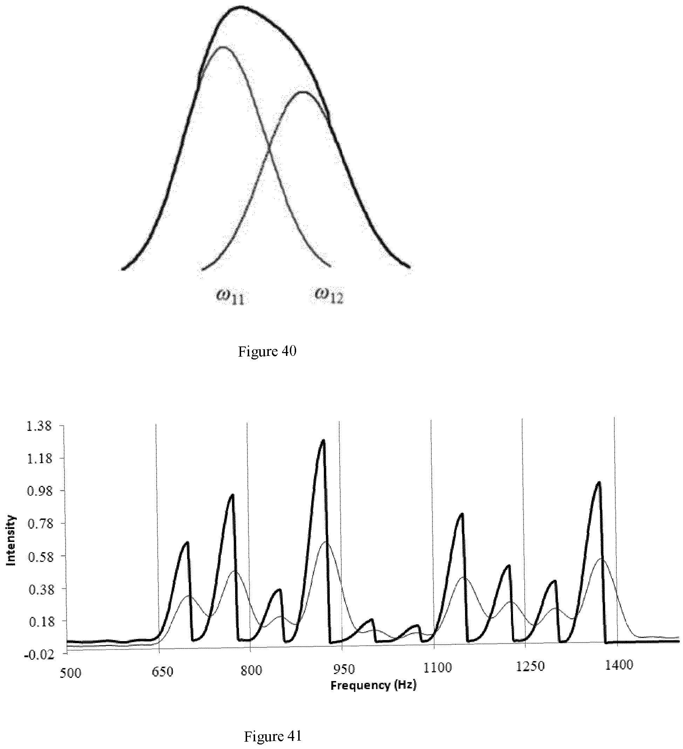

FIG. **40** is an illustration how Fourier Transform peak width affect resolution of the pixels in FIG. **39** in Example 3 of this invention.

FIG. **41** is an overlapping schematic diagram for a group of 10 magnetic resonance frequencies with equal distribution treated by current Fourier Transform and left-superimpose Fourier Transform in Example 3 of this invention.

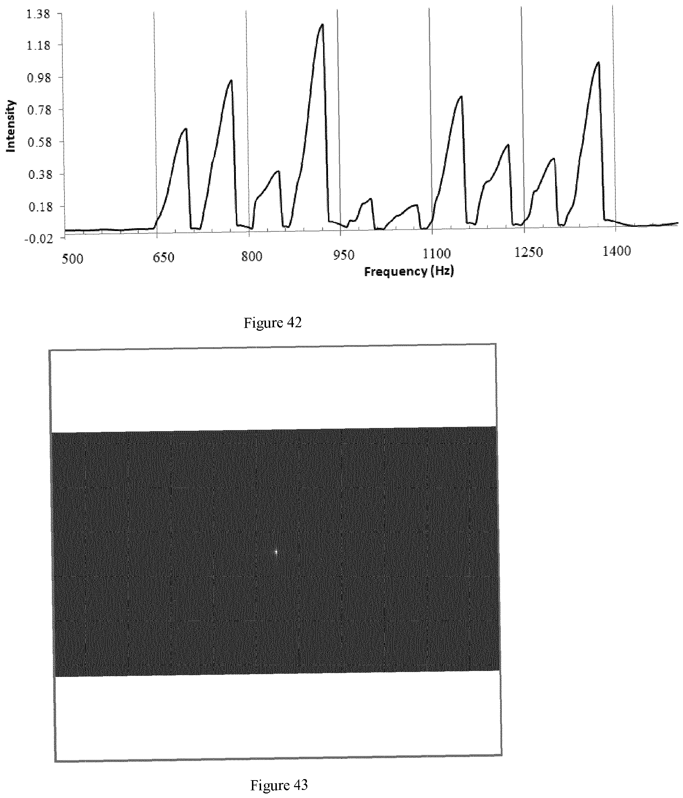

FIG. **42** is a schematic diagram of the same signal in FIG. **41** processed by a left-superimpose Fourier Transform matrix in Example 3 of this invention.

FIG. **43** is *k*-space raw data of an artificial membrane produce by magnetic resonance imaging in Example 3 of this invention.

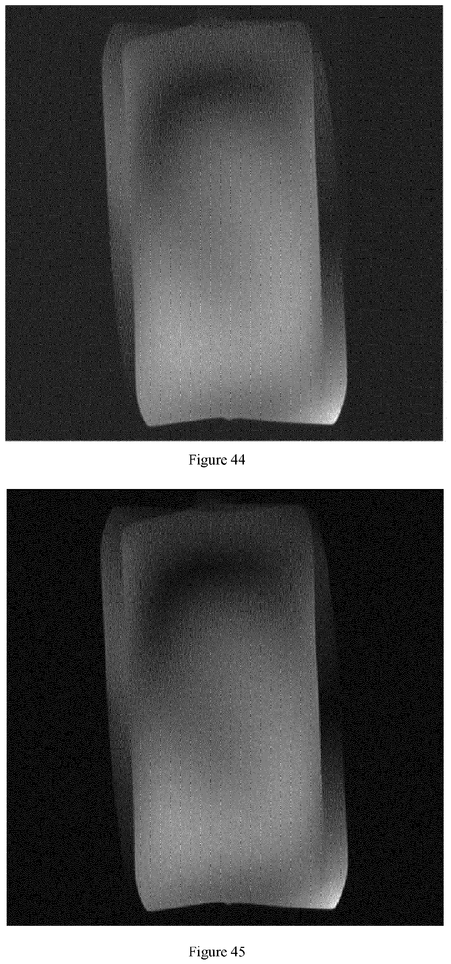

FIG. **44** is original image of the artificial membrane in Example 3 of this invention.

FIG. **45** is a grey-scale enhanced image for the raw data in FIG. **43** by multiplied with a diagonal superimpose matrix in Example 3 of this invention.

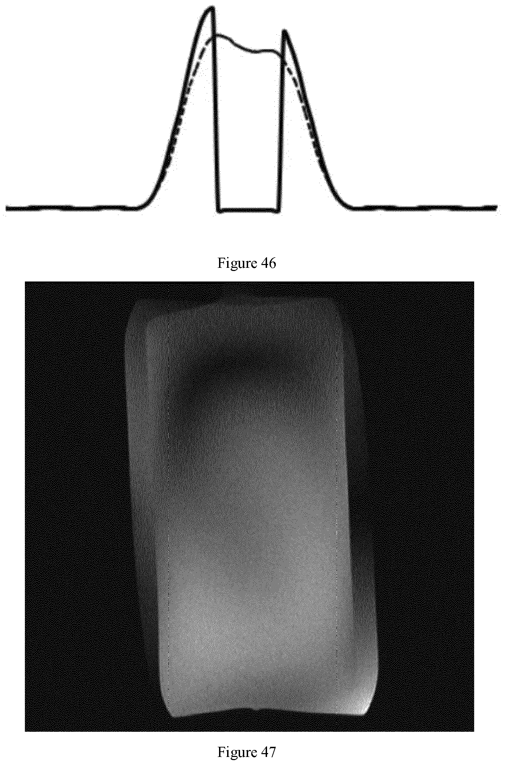

FIG. **46** is a schematic diagram by means of left-superimpose and right-superimpose synchronously for two adjacent peaks in Example 3 of this invention.

Figure **47** is a refined image processed by the superimpose Fourier Transform and extension of double imaging pixels with regard to the raw data of FIG. **43** in Example 3 of this invention.

## DETAILED DESCRIPTION OF THE INVENTION

The technical features of this invention are specified with accompanied drawings as following.

## EXAMPLE 1

In this exemplary embodiment, it provides a way to acquire Fourier Transform infrared spectra by superimposed peak shape. Infrared light generated from an infrared laser source passes an interferometer, sample chamber. The resulted infrared interferogram is measured on an infrared detector. Its infrared interferogram is sampling by a computer unit. Perform superimpose Fourier Transform to the sampled interferogram by the superimposing functions for individual infrared peaks to obtain infrared percentage transmittance and processed infrared spectrum is shown by a display unit. It results that intensity of individual peak is doubled and its peak width is narrowed by half.

Further in this exemplary embodiment, infrared spectroscopy based on interferometer and laser source is included. But not limit to the laser source and it can extent to Raman spectroscopy, near-infrared spectroscopy and far-infrared spectroscopy which operate in a similar principle and use laser source to acquire percentage transmittance.

Further in this exemplary embodiment, retardation time domain signals generated from an infrared interferometer are of cosine form, and thus the infrared interferogram is a linear combination signal that can meet requirement of Fourier Transform. There are several expressions to time t domain signal. A below equation is adopted for convenience:

$$f(t) = 2\pi K \cos(\omega_0 t) \qquad 0 \le t \le T \qquad \text{(Equation 1)}.$$

Three classical peak shapes will be produced by Fourier Transform from linear detection of a time domain signal in a single-beam infrared spectrometer.

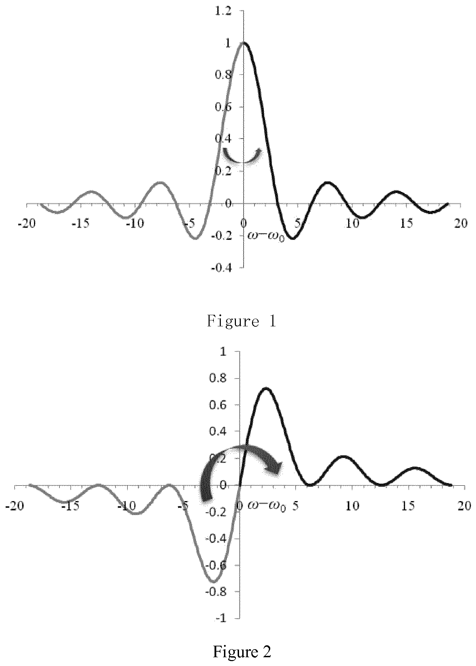

(1) Fourier Transform basic absorption peak shape as shown in FIG. **1,** its mathematic equation is a well-known function sinc:

$$A(\omega) = K \frac{\sin[(\omega - \omega_0)T]}{\omega - \omega_0} \qquad \text{(Equation 2)}.$$

As an infrared signal contains N of frequencies, the angular frequencies are expressed as series $\omega = 2m\pi/T$ and $\omega_0 = 2n\pi/T$, where m and n = 0, 1, 2, ······, N-1, its corresponding discrete absorption peak shape is:

$$A(\omega) = KT \left\{ \frac{\sin[2\pi(m - n)]}{2\pi(m - n)} \right\} \qquad \text{(Equation 2.1)}.$$

(2) Fourier Transform basic dispersion peak shape as shown in FIG. 2:

$$B(\omega) = K \frac{1 - \cos[(\omega - \omega_0)T]}{\omega - \omega_0} = KT \frac{\sin^2[(\omega - \omega_0)T/2]}{(\omega - \omega_0)T/2} \qquad \text{(Equation 3)}.$$

Its discrete dispersion peak shape is:

$$B(\omega) = KT \left\{ \frac{\sin^2[\pi(m-n)]}{\pi(m-n)} \right\} \quad \text{(Equation 3.1)}.$$

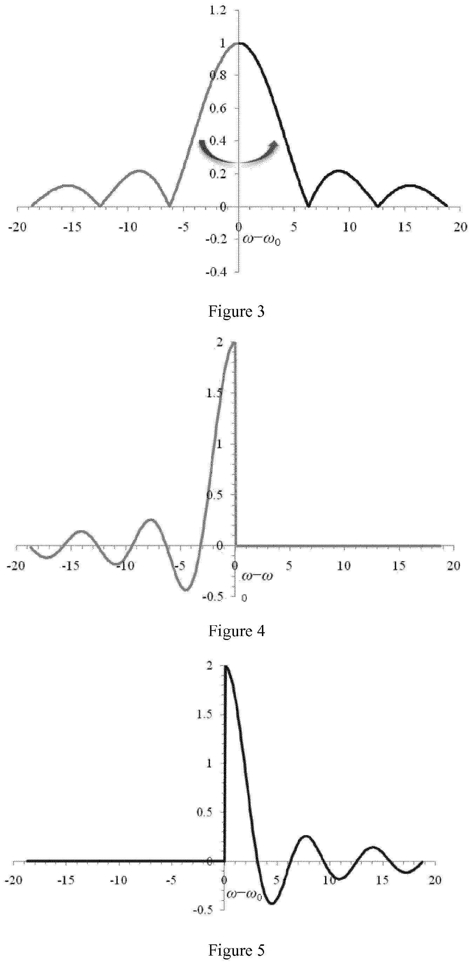

(3) Fourier Transform basic magnitude peak shape as shown in FIG. 3:

$$C(\omega) = \sqrt{[A(\omega)]^2 + [B(\omega)]^2} = K \left| \frac{2\sin[(\omega - \omega_0)T/2]}{\omega - \omega_0} \right| \quad \text{(Equation 4)}.$$

Its discrete magnitude peak shape is:

$$C(\omega) = KT \left| \frac{\sin[\pi(m-n)]}{\pi(m-n)} \right| \text{(Equation 4.1)}.$$

Further in this exemplary embodiment, define a pair of superimpose functions as:

$$\text{Simp}_1(x) = 1 + \frac{x}{|x|} = \left\{ \begin{array}{ll} 0 & x < 0 \\ 2 & x \geq 0 \end{array} \right. \quad \text{(Equation 5.1)}$$

$$\text{Simp}_2(x) = 1 - \frac{x}{|x|} = \left\{ \begin{array}{ll} 2 & x < 0 \\ 0 & x \geq 0 \end{array} \right. \quad \text{(Equation 5.2)}$$

The above superimpose functions equal to superpose half part of a symmetric or antisymmetric function to itself another half, either right-superimpose or left-superimpose. The function $\text{Simp}_1$ is defined as right-superimpose; the function $\text{Simp}_2$ with minus is left-superimpose. It has the same superimpose effect to replace $x/|x|$ with $|x|/x$ in the two superimpose functions.

A well-known special function in Fourier Transform is Sign function:

$$\text{sgn}(x) = \left\{ \begin{array}{ll} -1, & x < 0 \\ 1, & x \geq 0 \end{array} \right. \quad \text{(Equation 6)}.$$

The superimpose functions have following relationship with the Sign function:

$$\text{Simp}(x) = 1 \pm \text{sgn}(x) \quad \text{(Equation 7a)};$$

In real field, the superimpose function with plus (+) is exactly two times of another well-known function, Step function $H(x)$:

$$\text{Simp}_1(x) = 2 H(x) \quad \text{(Equation 7b)}.$$

Definition of Step function is:

$$H(x) = \left\{ \begin{array}{ll} 0, & x < 0 \\ 1, & x \geq 0 \end{array} \right. \quad \text{(Equation 8)}.$$

Further in this exemplary embodiment, with substituting independent variable $x = \omega - \omega_0$ in the superimpose functions, three new types of the basic peak shapes are generated by the above superimpose Fourier Transform.

(1) Fourier Transform superimposed absorption peak shape as shown in FIG. 4 for left-superimpose peak shape and in FIG. **5** for right-superimpose peak shape:

$$A'(\omega) = K\left\{\frac{\sin\left[(\omega-\omega_0)T\right]}{\omega-\omega_0} \pm \frac{\sin\left[(\omega-\omega_0)T\right]}{|\omega-\omega_0|}\right\}$$

$$= \left(1 \pm \frac{\omega-\omega_0}{|\omega-\omega_0|}\right) A(\omega) \qquad \text{(Equation 9)}.$$

Its corresponding discrete superimposed absorption peak shape is:

$$A'(\omega) = \left(1 \pm \frac{m-n}{|m-n|}\right) KT\left\{\frac{\sin\left[2\pi(m-n)\right]}{2\pi(m-n)}\right\} \qquad \text{(Equation 9.1)}.$$

(2) Fourier Transform superimposed dispersion peak shape is:

$$B'(\omega) = \left(1 \pm \frac{\omega-\omega_0}{|\omega-\omega_0|}\right) B(\omega) \qquad \text{(Equation 10)}.$$

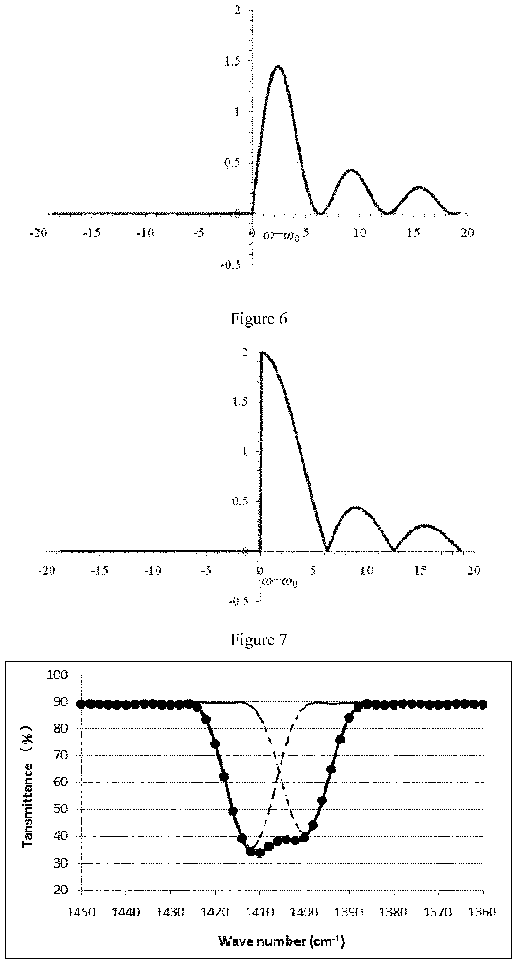

FIG. **6** shows a schematic drawing of a right-superimpose dispersion peak shape.
Its corresponding discrete superimposed dispersion peak shape is:

$$B'(\omega) = \left(1 \pm \frac{m-n}{|m-n|}\right) KT\left\{\frac{\sin^2\left[\pi(m-n)\right]}{\pi(m-n)}\right\} \qquad \text{(Equation 10.1)}.$$

(3) Fourier Transform superimposed magnitude peak shape is:

$$C'(\omega) = \left(1 \pm \frac{\omega-\omega_0}{|\omega-\omega_0|}\right) C(\omega) \qquad \text{(Equation 11)}.$$

FIG. 7 shows a schematic drawing of a right-superimpose magnitude peak shape.
Its corresponding discrete superimposed magnitude peak shape is:

$$C'(\omega) = \left(1 \pm \frac{m-n}{|m-n|}\right) KT\left|\frac{\sin\left[\pi(m-n)\right]}{\pi(m-n)}\right| \qquad \text{(Equation 11.1)}.$$

Further, the absorption peak shape shown in FIG. **1** is of axial symmetry. It was produced by Fourier Transform from the cosine signal with angular frequency $\omega_0$. After superimposed to right side, its peak width is narrowed by half and peak intensity is double; as well all of interferences (Gibbs phenomenon) in left side of the axis down to zero as in FIG, **5.** Similarly, the symmetric absorption peak can also flip to the left side to obtain the same consequences. The dispersion peak shape shown in FIG. **2** is of center symmetry and was produced by Fourier Transform from the same cosine signal. The peak is superimposed by a 180° of rotation. Because the magnitude peak is given from square root of absorption peak square plus dispersion peak square, its peak shape shown in FIG. **3** is of axial symmetry as well. The superimpose method provided in this embodiment is suitable to the dispersion and magnitude peak shapes accordingly.
Further, there are several approaches to execute the superimposition in this embodiment. Some approach may need to anticipate a few of parameters, such as peak amplitude. Sometimes, it could be better to preset the frequency range for implementing superimpose in light of spectral peak amount. Such that memory space and operation time of a computer are increased. The original causality of Fourier Transform is surpassed due to the extra step of superimpose. Meanwhile, it is a time consuming work for Fourier Transform to preset these parameters. The biggest drawback of Fourier Transform is the harmonic sidelobes around its principal peak as shown in FIG. **1** to FIG. **3,** commonly termed as Gibbs phenomenon. They are usually suppressed by an apodization function. Our new technology can demolish Gibbs effect in one side of the signal peak, but the another side should apply apodization to smooth the peak.

Further in this exemplary embodiment, for a cosine signal $K\cos(\omega_0 t)$ measured in time duration of $T$ where signal intensity is $K$ ($K$ = arbitrary real number) and frequency is $\omega_0$, we compare key technical parameters between current Fourier Transform theory and new Fourier Transform theory in Table **2** and Table **3** by means of numerical calculation. Height of the three peak shapes are all doubled and their peak widths are constricted by half. Thus, resolution of the cosine signal is increased doubly.

Table **2** The key parameters of current Fourier Transform

| Peak shape | Peak height | Half peak width | Full peak width |
|---|---|---|---|
| Absorption | $KT$ | $\dfrac{3.7910}{T}$ | $\dfrac{2\pi}{T}$ |
| Dispersion | $\pm 0.7246KT$ | $\dfrac{8.3488}{T}$ | $\dfrac{4\pi}{T}$ |
| Magnitude (absolute value) | $KT$ | $\dfrac{7.5820}{T}$ | $\dfrac{4\pi}{T}$ |

Table **3** The key parameters of superimpose Fourier Transform

| Peak shape | Peak height | Half peak width | Full peak width |
|---|---|---|---|
| Absorption | $2KT$ | $\dfrac{1.8955}{T}$ | $\dfrac{\pi}{T}$ |
| dispersion | $1.4492KT$ | $\dfrac{3.4138}{T}$ | $\dfrac{2\pi}{T}$ |
| Magnitude (absolute value) | $2KT$ | $\dfrac{3.7910}{T}$ | $\dfrac{2\pi}{T}$ |

In order to become better understood with regard to the approaches in this embodiment, the superimpose operation of the above three basic peak shapes of Fourier Transform can be implemented by following several approaches, but no limitation to them. Because the magnitude peak shape is usually used in Fourier Transform infrared spectroscopy, take magnitude peak shape as an instant in below implementations of superimpose Fourier Transform.

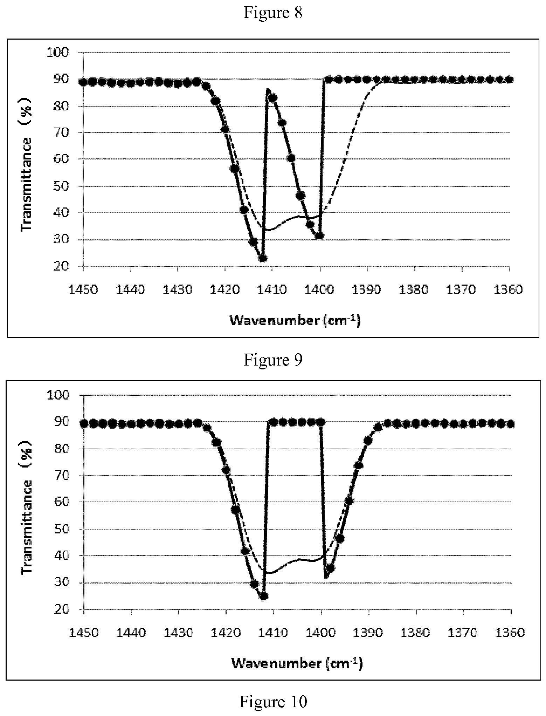

(1) After a full infrared spectrum is acquired with a routine procedure, reconstitute spectral peaks with their symmetric axes and peak widths at base individually. Although it is very time consuming to do so, it is still a means. According to these characters of the frequency domain signal in Table **2** and Table **3,** peak width of the basic peak shapes mainly depend on the sampling time $T$. Using Fourier Transform and superimpose with respective symmetries to double peak intensity and constrict peak width by half. The symmetric is defined as a Gauss distribution shape with corresponding peak coefficients. After calibration of phase difference and apodization of Gibbs sidelobes, use deconvolution algorithm to perform spectral peak superimpose. FIG. **8** is a simulated diagram of two adjacent infrared peaks indicated in thick solid line with data circle points; their peak wavenumbers are 1400cm$^{-1}$ and 1412cm$^{-1}$, respectively. While resolution is more than 6cm$^{-1}$, the two peaks almost merged together; it barely recognizes a concave valley between them. Current inverse convolution is to reconstruct the spectral peaks in the original spectrum by curve fitting as the two symmetric peaks in thin dash line shown in FIG. **8.** When applying superimpose Fourier Transform to the adjacent peaks as shown in FIG. **9** by left-superimpose technique, the two infrared peaks are separated at base line (thick solid line with data circle points). With regard to the original merged peaks (thin dash line), their infrared transmittance and wavenumbers are substantially recovered. Furthermore, as shown in FIG. **10,** these two peaks are implemented with respective left-superimpose and right-superimpose synchronously to separate completely into two peaks. A new deconvolution algorithm approach is proposed in this invention.

(2) The number of sampling points to Fourier Transform in a computer is always preset. The points must be large enough to ensure no distortion in signal frequencies. Infrared spectral resolution (retardation distance) should be also preset to acquire an interferogram. Any one of Equation **9,** Equation **10** and Equation **11** presented in this embodiment for superimpose Fourier Transform can be used to implement superimpose operation to cover every frequency component $\omega_0$ in an infrared spectrum without omission. This way would consume N times of superimpose operation time to N of $\omega_0$ components. Nevertheless, the superimpose operation can be optimized by grouping the frequency components. The frequency components are grouped as practical requirements and goals properly to group the components and then to implement superimpose Fourier Transform. The operation time will be reduced very effectively. Particularly, because speed of modern computer becomes faster and faster, the optimization of grouping frequency components would not spend much time in superimpose operation.

(3) According to demand of current Fourier Transform, a harmonic signal $f(t)$ must be discretized and digitally sampled. If there are $N$ of signal samples, it should have a set of discrete signal points $f(0)$, $f(1)$, $f(2)$, $\cdots$, $f(k)$, $\cdots$, $f(N$-1). $N$ of the data $F(0)$, $F(1)$, $F(2)$, $\cdots$ $F(k)$, $\cdots$, $F(N$-1) are acquired by discrete Fourier Transform to get a following Fourier Transform square matrix:

$$
\begin{pmatrix} F(0) \\ F(1) \\ F(2) \\ \vdots \\ F(k) \\ \vdots \\ F(N-1) \end{pmatrix} = \begin{pmatrix} 1 & 1 & 1 & \cdots & 1 \\ 1 & W & W^2 & \cdots & W^{N-1} \\ 1 & W^2 & W^4 & \cdots & W^{N-2} \\ \vdots & \vdots & \vdots & \ddots & \vdots \\ 1 & W^k & W^{2k} & \cdots & W^{N-k} \\ \vdots & \vdots & \vdots & \ddots & \vdots \\ 1 & W^{N-1} & W^{N-2} & \cdots & W \end{pmatrix} \begin{pmatrix} f(0) \\ f(1) \\ f(2) \\ \vdots \\ f(k) \\ \vdots \\ f(N-1) \end{pmatrix} \qquad \text{(Equation 12),}
$$

where factor $W = exp(-i2\pi/N)$ in the $N \times N$ of Fourier Transform matrix.

In this exemplary embodiment, above equation is simply multiplied by a specific diagonal superimpose matrix as below to implement the superimpose operation:

$$
\begin{pmatrix} F(0) \\ F(1) \\ F(2) \\ \vdots \\ F(k) \\ \vdots \\ F(N-1) \end{pmatrix} = \begin{pmatrix} 1 & 1 & 1 & 1 & \cdots & 1 \\ 1 & W & W^2 & W^3 & \cdots & W^{N-1} \\ 1 & W^2 & W^4 & W^6 & \cdots & W^{N-2} \\ \vdots & \vdots & \vdots & \vdots & \ddots & \vdots \\ 1 & W^k & W^{2k} & W^{3k} & \cdots & W^{N-k} \\ \vdots & \vdots & \vdots & \vdots & \ddots & \vdots \\ 1 & W^{N-1} & W^{N-2} & W^{N-3} & \cdots & W \end{pmatrix} \begin{pmatrix} 2(0) & 0 & 0 & 0 & \cdots & 0 \\ 0 & 2(0) & 0 & 0 & \cdots & 0 \\ 0 & 0 & 2(0) & 0 & \cdots & 0 \\ \vdots & \vdots & \vdots & \vdots & \ddots & \vdots \\ 0 & 0 & 0 & 0 & \cdots & 0 \\ \vdots & \vdots & \vdots & \vdots & \ddots & \vdots \\ 0 & 0 & 0 & 0 & \cdots & 2(0) \end{pmatrix} \begin{pmatrix} f(0) \\ f(1) \\ f(2) \\ \vdots \\ f(k) \\ \vdots \\ f(N-1) \end{pmatrix} \qquad \text{(Equation 13).}
$$

Further, we can scan row-to-row, or $\Delta N$-row-to $\Delta N$-row for a desired resolution $\Delta N$. The corresponding slop variation is compared to determine the diagonal elements of the inserted matrix to be 2 or 0 as displayed below.

$$\begin{pmatrix} 2 & 0 & 0 & 0 & \cdots & 0 \\ 0 & 2(0) & 0 & 0 & \cdots & 0 \\ 0 & 0 & 2(0) & 0 & \cdots & 0 \\ \vdots & \vdots & \vdots & \vdots & \ddots & \vdots \\ 0 & 0 & 0 & 0 & \cdots & 0 \\ \vdots & \vdots & \vdots & \vdots & \ddots & \vdots \\ 0 & 0 & 0 & 0 & \cdots & 2(0) \end{pmatrix} \quad \text{(Equation 13.1).}$$

Take a value of 2 for the diagonal matrix element when the slope of front point is positive in right-superimpose operation; to take value of 0 for the diagonal matrix element as slope of the front point is negative or near to 0. Alternatively, the diagonal matrix element is to be 2 or 0 by looking over front peak value whether it is increased, steady or decreased. It is opposite in left-superimpose operation. Benefit of this approach is only deal with causality like current Fourier Transform. Although no parameter to be preset, spectral baseline could be enforced to zero. There is no relevance between scanning of row-to-row in the diagonal matrix and the rows in Fourier Transform matrix. Therefore, Fast Fourier Transform (FFT) can be executed synchronously. Since Fast Fourier Transform generally uses a square matrix, for a 3295 retardation lines and 709 wavenumber rows, zero-filling technique should be used to implement superimpose Fourier Transform and Fast Fourier Transform simultaneously.

(4) In this embodiment of the invention, two superimpose functions are initiated in Equation **5.1** and Equation **5.2.**: adjacent harmonic signals can be superimposed for the front peak by left (or right) superimpose and for the back peak by right (or left) superimpose synchronously. As shown in FIG. **10,** resolution of two partially overlapping peaks can be increased as much as 4 times of that by current Fourier Transform, where left-superimpose is applied to left peak 1; right-superimpose applied to right peak 2, so that resolution of these two adjacent peaks achieves 4 times consequently.

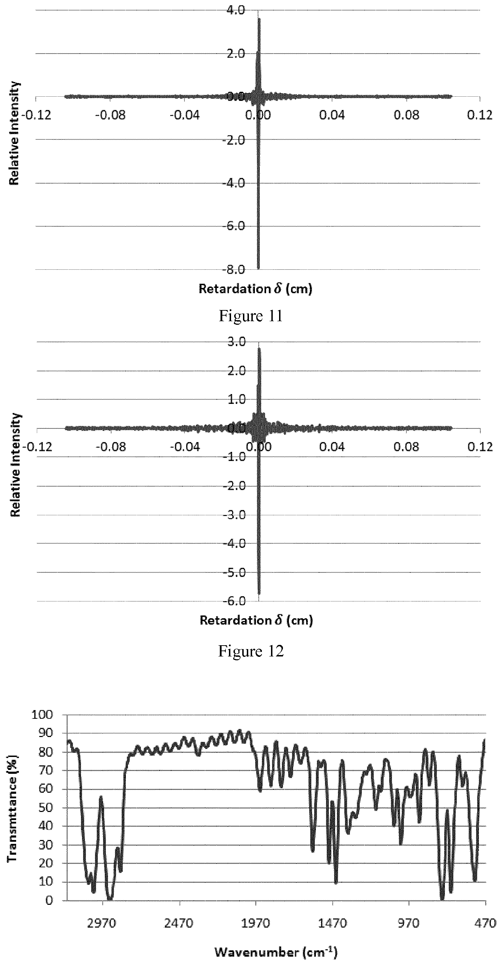

Further in this exemplary embodiment, we used a Nicolet Protégé 460 commercial Fourier Transform infrared spectrometer equipped with emission wavelength of 632.8 nm ($6.328 \times 10^{-5}$ cm) of Helium-Neon infrared light source. Interferogram of an infrared signal is obtained in multiple of this basic wavelength. The interferometer in the embodiment was double-sided optical path with 3295 of retardation steps, and 709 of wavenumber readings with 3.85 cm$^{-1}$ of interval displacement. Routine procedure of infrared spectroscopy is to measure infrared spectrum of background first and then infrared spectrum of a sample; further infrared percentage transmittance spectrum is acquired by deducting the background (it should be infrared absorption spectrum to take logarithm). FIG. **11** is raw infrared interferogram of the background, and FIG. **12** is raw infrared interferogram of Polystyrene.

Because Polystyrene membrane often is used as a reference standard in resolution determination of an infrared spectrometer, it is a good exemplary sample used to elaborate merits of the superimpose Fourier Transform.

An infrared spectrum of Polystyrene in wavenumbers from 470- 3200cm$^{-1}$ by current Fourier Transform technique is shown in FIG. **13.** Apodization was conducted with a cosine function or Happ-Genzel function. This original infrared spectrum acquired by current Fourier Transform with resolution of 16 cm$^{-1}$ exhibits just four characteristic peaks at wavenumbers 2854cm$^{-1}$, 2924cm$^{-1}$, 3028cm$^{-1}$ and 3062cm$^{-1}$ in region of 2970-3200cm$^{-1}$; only one characteristic peak at wavenumber 1601cm$^{-1}$ in region of 1550cm$^{-1}$-1650cm$^{-1}$.

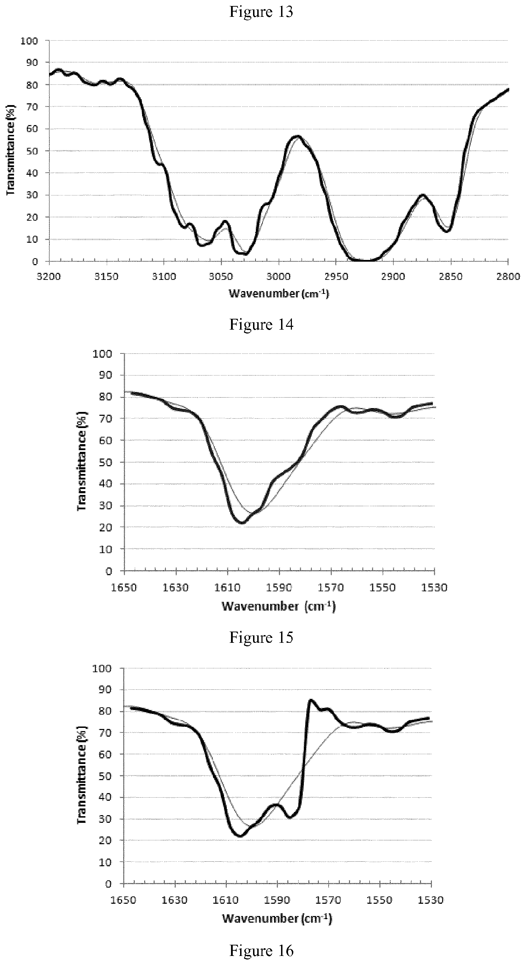

After applied superimpose Fourier Transform to the same raw infrared interferogram signals in FIG. **12** and FIG. **13,** seven characteristic peaks at wavenumbers 2854cm$^{-1}$, 2924cm$^{-1}$, 3008cm$^{-1}$, 3028cm$^{-1}$, 3066cm$^{-1}$, 3082cm$^{-1}$ and 3105cm$^{-1}$ appeared in region of 2970-3200cm$^{-1}$ as shown in FIG. **14,** wherein thick line represents infrared spectrum acquired by superimpose Fourier Transform provided in this embodiment (resolution 16cm$^{-1}$ with superimpose step to every 7.7cm$^{-1}$ of wavenumber interval); thin line is the original infrared spectrum acquired by current Fourier Transform (resolution 16cm$^{-1}$). In region of 1550cm$^{-1}$-1650cm$^{-1}$, it resolved two characteristic peaks at wavenumbers 1585cm$^{-1}$ and 1605cm$^{-1}$ as shown in FIG. **15.** When key wavenumbers of these two peaks were implemented by left-superimpose and right-superimpose synchronously, the characteristic peaks at 1585cm$^{-1}$ and 1605cm$^{-1}$ were separated further as in FIG. **16.** In base of the raw data acquired with resolution 16cm$^{-1}$, superimpose Fourier Transform provided in this embodiment demonstrated a good result that matched well with infrared spectrum of polystyrene acquired by a high resolution of 4cm$^{-1}$.

Further, the technique provided in this embodiment can extend to handle signals containing free induction decay and phase shift, and corresponding peak shapes generated by Fourier Transform, such as Lorentz peak shapes. Since the free induction decay and phase shift are of exponential forms, these exponential components are actually equivalent to apodization functions multiplied to the signals. Their expressions of the corresponding peak shapes remain symmetric superimpose.

**EXAMPLE 2**

This exemplary embodiment describes a nuclear magnetic resonance spectrometry based on superimpose Fourier Transform to obtain superimpose peak shapes of nuclear magnetic resonance. It can be implemented as following procedures:

Step S1: a time t domain (0 to $T$) signal of nuclear magnetic resonance is acquired from dual detection channels,

$$f(t) = 2\pi K\, e^{-t/\tau}\, [\cos(\omega_0 t) + i\, \sin(\omega_0 t)] \qquad 0 \le t \le T \text{ (Equation 14)},$$

where $\omega_0$ is nuclear magnetic resonance frequency of a nucleus with intensity $K$ and free induction decay coefficient $\tau$.
Step S2: time domain signal of nuclear magnetic resonance acquired in step S1 is operated by Fourier Transform to get basic absorption, dispersion and magnitude peak shapes of Fourier Transform. They are sampling discretely to produce discrete basic absorption, dispersion and magnitude peak shapes, respectively;
Step S3: The peak shapes obtained in step S2 is superimposed through a suitable superimpose function to obtain superimposed absorption, dispersion and/or magnitude peak shapes by superimpose Fourier Transform. They are sampling discretely to produce discrete absorption, dispersion and magnitude superimposed peak shapes, respectively;
Step S4: A corresponding nuclear magnetic resonance spectrum is obtained from the above superimposed peak shapes.

Further in this exemplary embodiment, although the nuclear spin relaxation in step S1 gives very valuable information of the nucleus, it leads to be not just loss of signal response, but also enlarges width of various Fourier transformed peak shapes after the signal decays to zero. The faster signal decays, the wider peak width is. For the sake of expounding, we assume no decay in a signal, that is, $\tau \to \infty$. Above time domain signal produces three classical peak shapes by current Fourier Transform.

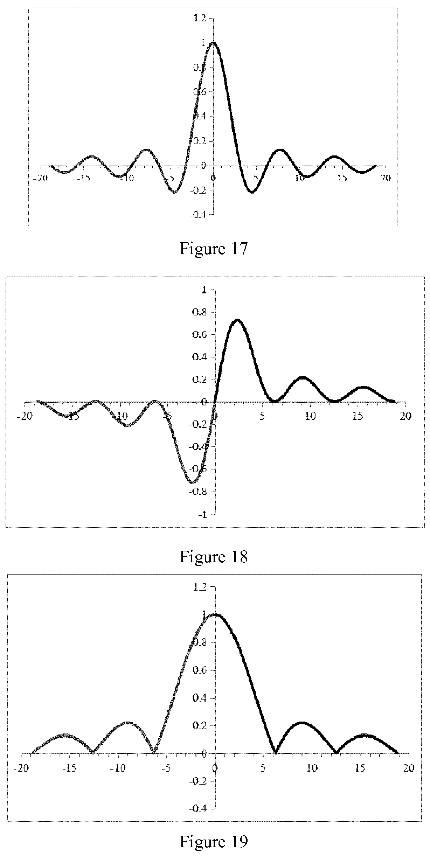

(1) The basic absorption peak shape of Fourier Transform without free induction decay as shown in FIG. **17**, its mathematic expression is a well-known function sinc:

$$A(\omega) = 2K \frac{\sin\left[(\omega - \omega_0)T\right]}{\omega - \omega_0} \qquad \text{(Equation 15)}.$$

For $N$ of composed nuclear spin frequencies, the angular frequencies are expressed by series $\omega = 2m\pi/T$ and $\omega_0 = 2n\pi/T$, where m and n = 0, 1, 2, ⋯ ⋯, N-1, its discrete basic absorption peak shape is:

$$A(\omega) = 2KT \left\{ \frac{\sin\left[2\pi(m-n)\right]}{2\pi(m-n)} \right\} \qquad \text{(Equation 15.1)}.$$

(2) The basic dispersion peak shape of Fourier Transform is shown in FIG. **18**,

$$B(\omega) = \pm 2K \frac{1 - \cos[(\omega - \omega_0)T]}{\omega - \omega_0}$$

$$= \pm KT \frac{\sin^2[(\omega - \omega_0)T/2]}{(\omega - \omega_0)T/2} \qquad \text{(Equation 16)}.$$

The corresponding discrete basic dispersion peak shape is:

$$B(\omega) = \pm 2KT \left\{ \frac{\sin^2[\pi(m-n)]}{\pi(m-n)} \right\}$$ (Equation 16.1).

(3) The basic magnitude peak shape (also termed as absolute value peak shape) of Fourier Transform is shown in FIG. 19:

$$C(\omega) = \sqrt{[A(\omega)]^2 + [B(\omega)]^2} = 2K \left| \frac{2\sin[(\omega - \omega_0)T/2]}{\omega - \omega_0} \right|$$ (Equation 17).

The corresponding discrete basic magnitude peak shape is:

$$C(\omega) = 2KT \left| \frac{\sin[\pi(m-n)]}{\pi(m-n)} \right|$$ (Equation 17.1).

Further in this exemplary embodiment, a pair of superimpose functions for implementation of superimpose Fourier Transform are initiated:

$$\text{Simp}_1(x) = 1 + \frac{x}{|x|} = \begin{cases} 0 & x < 0 \\ 2 & x \geq 0 \end{cases}$$ (Equation 18.1);

$$\text{Simp}_2(x) = 1 - \frac{x}{|x|} = \begin{cases} 2 & x < 0 \\ 0 & x \geq 0 \end{cases}$$ (Equation 18.2).

The above superimpose functions equal to superpose half part of a symmetric or antisymmetric function to another half of itself, either right-superimpose or left-superimpose. The function $\text{Simp}_1$ is defined as right-superimpose; the function $\text{Simp}_2$ with minus is left-superimpose. It has the same superimpose effect to replace $x/|x|$ with $|x|/x$ in the two superimpose functions.

Further, a special function commonly seen in Fourier Transform is Sign function:

$$\text{sgn}(x) = \begin{cases} -1, & x < 0 \\ 1, & x \geq 0 \end{cases}$$ (Equation 19).

The superimpose functions have following relationship with the Sign function:

$$\text{Simp}(x) = 1 \pm \text{sgn}(x)$$ (Equation 20).

In real field, the superimpose function with plus (+) is exactly two times of another well-known function, Step function $H(x)$:

$$\text{Simp}_1(x) = 2\, H(x)$$ (Equation 21).

Definition of Step function is:

$$H(x) = \begin{cases} 0, & x < 0 \\ 1, & x \geq 0 \end{cases}$$ (Equation 22).

Further in this exemplary embodiment, with substituting independent variable $x = \omega - \omega_0$ in the superimpose functions, three new types of the basic peak shapes are generated by the above superimpose Fourier Transform.

(1) Fourier Transform superimposed absorption peak shape,

$$A'(\omega) = 2K\left\{\frac{\sin\left[(\omega - \omega_0)T\right]}{\omega - \omega_0} \pm \frac{\sin\left[(\omega - \omega_0)T\right]}{|\omega - \omega_0|}\right\}$$

$$= \left(1 \pm \frac{\omega - \omega_0}{|\omega - \omega_0|}\right) A(\omega) \qquad \text{(Equation 23)}.$$

Its corresponding discrete superimposed absorption peak shape is:

$$A'(\omega) = 2\left(1 \pm \frac{m - n}{|m - n|}\right) KT\left\{\frac{\sin\left[2\pi(m - n)\right]}{2\pi(m - n)}\right\} \qquad \text{(Equation 23.1)}.$$

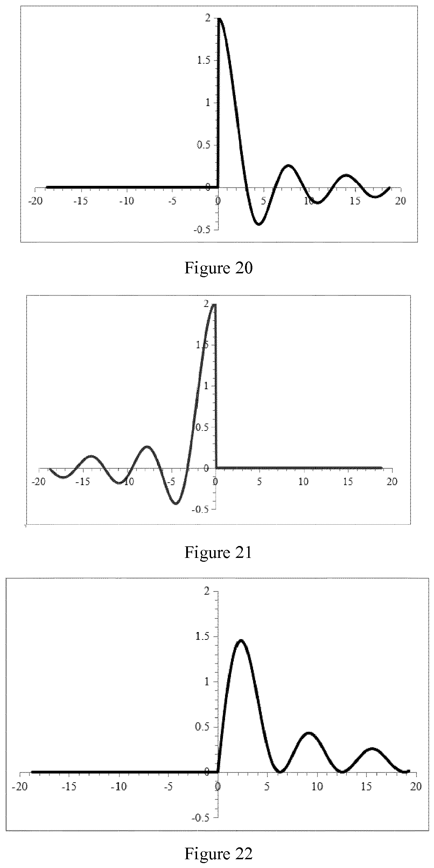

FIG. **20** and FIG. **21** are schematic drawings of right-superimpose Fourier Transform absorption peak shape and left-superimpose Fourier Transform absorption peak shape, respectively.

(2) Fourier Transform superimposed dispersion peak shape,

$$B'(\omega) = \left(1 \pm \frac{\omega - \omega_0}{|\omega - \omega_0|}\right) B(\omega) \qquad \text{(Equation 24)}.$$

Its corresponding discrete superimposed dispersion peak shape is:

$$B'(\omega) = 2\left(1 \pm \frac{m - n}{|m - n|}\right) KT\left\{\frac{\sin^2\left[\pi(m - n)\right]}{\pi(m - n)}\right\} \qquad \text{(Equation 24.1)}.$$

FIG. **22** is a schematic drawing of right-superimpose Fourier Transform dispersion peak shape.

(3) Fourier Transform superimposed magnitude peak shape,

$$C'(\omega) = \left(1 \pm \frac{\omega - \omega_0}{|\omega - \omega_0|}\right) C(\omega) \qquad \text{(Equation 25)}.$$

Its corresponding discrete superimposed magnitude peak shape is:

$$C'(\omega) = 2\left(1 \pm \frac{m - n}{|m - n|}\right) KT\left|\frac{\sin\left[\pi(m - n)\right]}{\pi(m - n)}\right| \qquad \text{(Equation 25.1)}.$$

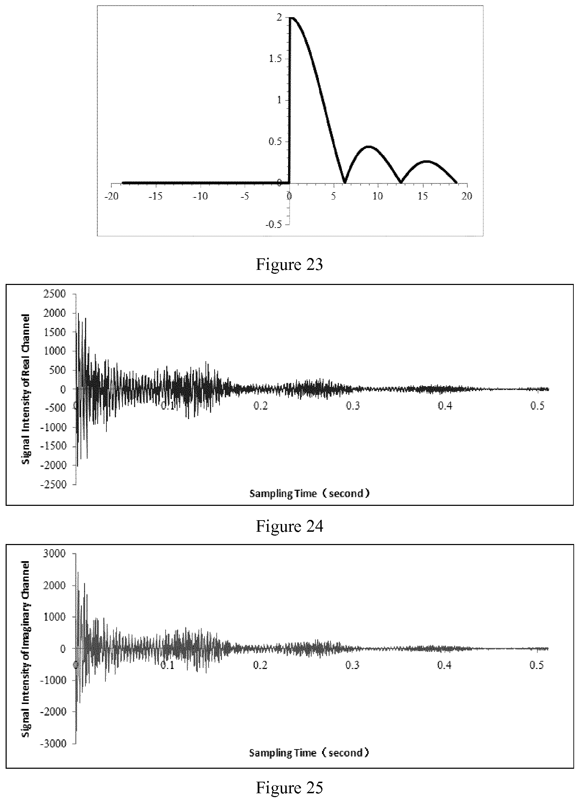

FIG. **23** is a schematic drawing of right-superimpose Fourier Transform magnitude peak shape.

Further in this exemplary embodiment, superimpose Fourier Transform is a fundamental improvement to current theory and technique of Fourier Transform, and initiates a mathematic approach to superimpose the basic peak shapes of Fourier Transform, including absorption, dispersion and magnitude (or power) peak shapes. The superimpose operations based on symmetric characteristics of these peak shapes achieved 100% improvement of signal resolution, intensity and signal-to-noise-ratio. FIG. **17** shows an absorption peak of Fourier Transform produced from a cosine signal of angular frequency $\omega_0$, which is of axial symmetry. After right-superimpose, its peak width is narrowed by half, peak height becomes double, and interference peaks (Gibbs phenomenon) at left side of the flipping axis (former symmetric axis) are demolished to zero as shown in FIG. **20.** It has the same effect to make left-superimpose for the absorption peak as shown in FIG. **21.** FIG. **18** is a dispersion peak shape by Fourier Transform from the same signal. It is of center symmetry and can be superimposed by rotation of 180°. Because the magnitude peak is given from square root of absorption peak square plus dispersion peak square, its peak shape shown in FIG. **19** is of axial symmetry as well. The superimpose method provided in this embodiment is suitable to the dispersion and magnitude peak shapes accordingly.

In this exemplary embodiment we presented superimpose Fourier Transform to acquire a nuclear magnetic resonance spectrum. This technique changes common concept of spectral peak shape, and invent a way of asymmetric peak shape. It ensures no information loss and raises quality of the signal analyses. The biggest drawback of Fourier Transform is the harmonic sidelobes around its principal peak as shown in FIG. **17** to FIG. **19,** commonly termed as Gibbs phenomenon. They are usually suppressed by an apodization function. Our new technology can demolish Gibbs effect in one side of the signal peak, but the another side should apply apodization to smooth the peak. Further in this exemplary embodiment, for a nuclear magnetic resonance signal measured in time duration of $T$ where signal intensity is $K$ ($K$ = arbitrary real number) and frequency is $\omega_0$, we compare key technical parameters between current Fourier Transform theory and new Fourier Transform theory in Table **4** and Table **5** by means of numerical calculation. Height of the three peak shapes are all doubled and their peak widths are narrowed by half. Thus, resolution of the cosine signal is increased doubly.

Table **4** The key parameters of current Fourier Transform in detection of dual channels

| Peak shape | Peak height | Half peak width | Full peak width |
|---|---|---|---|
| Absorption | $2KT$ | $\dfrac{3.7910}{T}$ | $\dfrac{2\pi}{T}$ |
| Dispersion | $\pm 1.4492KT$ | $\dfrac{8.3488}{T}$ | $\dfrac{4\pi}{T}$ |
| Magnitude (absolute value) | $2KT$ | $\dfrac{7.5820}{T}$ | $\dfrac{4\pi}{T}$ |

Table **5** The key parameters of superimpose Fourier Transform in detection of dual channels

| Peak shape | Peak height | Half peak width | Full peak width |
|---|---|---|---|
| Absorption | $4KT$ | $\dfrac{1.8955}{T}$ | $\dfrac{\pi}{T}$ |
| dispersion | $2.8984KT$ | $\dfrac{3.4138}{T}$ | $\dfrac{2\pi}{T}$ |
| Magnitude (absolute value) | $4KT$ | $\dfrac{3.7910}{T}$ | $\dfrac{2\pi}{T}$ |

Further, the superimpose operation of the above three basic peak shapes of Fourier Transform can implemented by following several approaches, but no limitation to them. Fourier Transform nuclear magnetic resonance spectrometry uses a single channel or dual channels, absorption peak shape or magnitude peak shapes . In the following operations, absorption peak shape from detectors is used as an instant to implement superimpose Fourier Transform. Nuclear magnetic resonance spectrometer used here is QE 300 made by GE limited of USA with a magnetic field of 7 teslas. Spectral measurement of Ethylbenzene was executed by 300 MHz of proton nuclear magnetic resonance spectrometry. The main working parameters are: dwell time 250μs, scanning bandwidth 4000Hz, offset frequency 1850Hz, sampling time 0.512s, 2048 of data points, sampling point interval 1.95Hz, applied an exponential apodization function with a line width 0.2Hz.

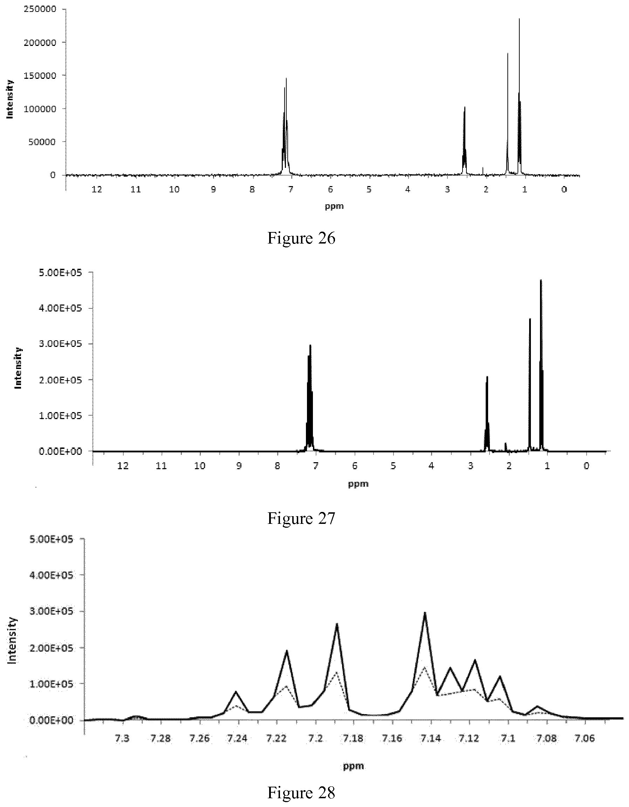

(1) FIG. **24** shows a free induction decay signal of Ethylbenzene acquired in real channel detector of the 300MHz nuclear magnetic resonance spectrometer; FIG. **25** is a free induction decay signal of Ethylbenzene acquired in imaginary channel detector. Nuclear magnetic resonance spectrum of Ethylbenzene from the free induction decay signals of FIG. **24** and FIG. **25** by current Fourier Transform technique is shown in FIG. **26**. It appeared three groups of proton spin-spin coupling characteristic peaks: Methyl peak at 1.1 to 1.2 ppm, Methylene peak at 2.5 to 2.6 ppm, phenyl peak at 7.1 to 7.2 ppm, and an impurity solvent peak at 1.466 ppm.

Further in this exemplary embodiment, the raw data in FIG. **24** and FIG. **25** were implemented by superimpose Fourier Transform presented in this embodiment according to Equation **23**. In order to cover every nuclear magnetic resonance frequency, we can implement superimpose operation together for all of individual frequency $\omega_0$ components. This way would consume N times of superimpose operation time to N of $\omega_0$ components. Nevertheless, the superimpose operation can be optimized by grouping the frequency components as practical situation. For example, since Ethylbenzene has three groups of proton spin-spin coupling peaks, the left-superimpose Fourier Transform was implemented respectively to these three groups. It reduced the operation time very effectively. Particularly, because speed of modern computer becomes faster and faster, the optimization of grouping frequency components would not spend much time in superimpose operation. FIG. **27** is a superimpose Fourier Transform nuclear magnetic resonance spectrum of Ethylbenzene, in which all of the peak intensity were doubled. FIG. **28** is a zoomed proton nuclear magnetic resonance spectrum of the phenyl in FIG. **27,** where spectral peaks of left-superimpose Fourier Transform were indicated in thick solid line and spectral peaks of current Fourier Transform indicated in thin dash line. The identification was obviously enhanced through a comparison in FIG. 28: 5 peaks were resolved at 7.08 to 7.15 ppm (2 peaks belong. to ortho phenyl hydrogens and three peaks belong to para phenyl hydrogens), not merely 4 peaks in the original spectrum. Although the peak intensities were increased here, it should be notified that the narrowing effect of peak width was not reflected due to using 2048 sampling points relative to 4000Hz of frequency bandwidth, such that each peak was allocated with only 3 to 4 data points by averaging. It just ensured no distortion in signal frequency.

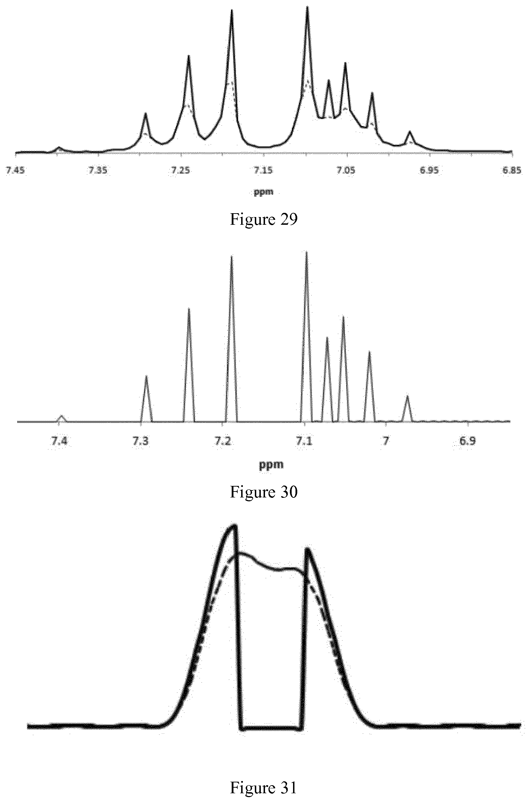

After the original free induction decay signals were simulated up to 4096 sampling points, the peak intensities and peak widths were improved by 100% as shown in FIG. **29,** where a simulated left-superimpose Fourier transform spectrum (in thick solid line) is compared with the current Fourier Transform spectrum (in thin dash line).

(2) According to demand of current Fourier Transform, a harmonic signal $f(t)$ must be discretized and digitally sampled. If there are $N$ of signal samples, it should have a set of discrete signal points $f(0)$, $f(1)$, $f(2)$, $\cdots$, $f(k)$, $\cdots$, $f(N-1)$. $N$ of the data $F(0)$, $F(1)$, $F(2)$, $\cdot\cdot$ $F(k)$, $\cdots$ $F(N-1)$ are acquired by discrete Fourier Transform, which is expressed by a matrix:

$$
\begin{pmatrix} F(0) \\ F(1) \\ F(2) \\ \vdots \\ F(k) \\ \vdots \\ F(N-1) \end{pmatrix} = \begin{pmatrix} 1 & 1 & 1 & \cdots & 1 \\ 1 & W & W^2 & \cdots & W^{N-1} \\ 1 & W^2 & W^4 & \cdots & W^{N-2} \\ \vdots & \vdots & \vdots & \ddots & \vdots \\ 1 & W^k & W^{2k} & \cdots & W^{N-k} \\ \vdots & \vdots & \vdots & \ddots & \vdots \\ 1 & W^{N-1} & W^{N-2} & \cdots & W \end{pmatrix} \begin{pmatrix} f(0) \\ f(1) \\ f(2) \\ \vdots \\ f(k) \\ \vdots \\ f(N-1) \end{pmatrix} \quad \text{(Equation 26).}
$$

where factor $W = exp(-i2\pi/N)$ in the $N{\times}N$ of Fourier Transform matrix.

The above equation is simply multiplied by a specific diagonal superimpose matrix as below to implement the superimpose operation:

$$
\begin{pmatrix} F(0) \\ F(1) \\ F(2) \\ \vdots \\ F(k) \\ \vdots \\ F(N-1) \end{pmatrix} = \begin{pmatrix} 1 & 1 & 1 & 1 & \cdots & 1 \\ 1 & W & W^2 & W^3 & \cdots & W^{N-1} \\ 1 & W^2 & W^4 & W^6 & \cdots & W^{N-2} \\ \vdots & \vdots & \vdots & \vdots & \ddots & \vdots \\ 1 & W^k & W^{2k} & W^{3k} & \cdots & W^{N-k} \\ \vdots & \vdots & \vdots & \vdots & \ddots & \vdots \\ 1 & W^{N-1} & W^{N-2} & W^{N-3} & \cdots & W \end{pmatrix} \begin{pmatrix} 2(0) & 0 & 0 & 0 & \cdots & 0 \\ 0 & 2(0) & 0 & 0 & \cdots & 0 \\ 0 & 0 & 2(0) & 0 & \cdots & 0 \\ \vdots & \vdots & \vdots & \vdots & \ddots & \vdots \\ 0 & 0 & 0 & 0 & \cdots & 0 \\ \vdots & \vdots & \vdots & \vdots & \ddots & \vdots \\ 0 & 0 & 0 & 0 & \cdots & 2(0) \end{pmatrix} \begin{pmatrix} f(0) \\ f(1) \\ f(2) \\ \vdots \\ f(k) \\ \vdots \\ f(N-1) \end{pmatrix} \quad \text{(Equation 27).}
$$

Further, we can scan row-to-row, or $\Delta N$-row-to $\Delta N$-row for a desired resolution $\Delta N$ to determine the diagonal matrix elements to be 2 or 0, or a small number close to zero. Since sampling points of nuclear magnetic resonance spectrometry is based on computer binary system, take arrangement mode of $2\cdots2$, $0\cdots0$, $2\cdots2$, $0\cdots0$, $\cdots\cdots$ in the diagonal matrix elements to implement left-superimpose; take mode of $0\cdots0$, $2\cdots2$, $0\cdots0$, $2\cdots2$, $\cdots\cdots$ in the diagonal matrix elements to implement right-superimpose.

Further in this exemplary embodiment, a result by using the matrix operation of Equation **27** to implement left-superimpose Fourier Transform is shown in FIG. **30** that is a partial nuclear magnetic resonance spectrum of Ethylbenzene and 8 of proton spin-spin coupling peaks were separated completely.

There is no relevance between scanning of row-to-row in the diagonal matrix and the rows in Fourier Transform matrix. Therefore, Fast Fourier Transform (FFT) can be executed synchronously.

(3) In this embodiment of the invention, two superimpose functions are initiated in Equation **18.1** and Equation **18.2.**: adjacent harmonic signals can be superimposed for the front peak by left (or right) superimpose and for the back peak by right (or left) superimpose synchronously. As shown in FIG. **31,** resolution of two partially overlapping peaks (in dash line) can be increased as much as 4 times of that by current Fourier Transform, where superimpose effect is indicated by solid line.

Further, the superimpose function can be used to handle the signals with free induction decay and phase shift. The free induction decay and phase shift are in exponential forms Therefore, these exponential components are actually equivalent to apodization functions multiplied to the signals. Their expressions of the corresponding peak shapes remain symmetric superimpose.

**EXAMPLE 3**

In this exemplary embodiment, it provides an approach to acquire Fourier Transform magnetic resonance imaging by superimposed peak shapes. A magnetic resonance imaging signal is of form $I+iQ$, where $I$ is in-phase signal component and $Q$ is orthogonal signal component, termed as $k$-space signal. The resonance frequency $\omega_0$ in a principal magnetic field $B_0$ and proton relaxation response both are calculated as constants in signal processing of $k$-space. Taking one-dimensional frequency coding as an example, dedicate magnetic resonance gradient frequency as $\omega_x$.

$$\omega_x = \gamma G_x x \quad \text{(Equation 28)},$$

where $\gamma$ is proton gyromagnetic ratio, and $G_x$ is a gradient magnetic field along x-axis.
Setting proton spin intensity as p, time domain signal of $k$-space in magnetic resonance imaging is:

$$S(t_x) = C \int \rho \, e^{i\gamma G_x x t_x} \, dx \quad \text{(Equation 29)},$$

where C is a constant related to the principal magnetic field and proton relaxation. Usually for convenience, the gradient frequency $\omega_x$ is taken place by k parameter, which is defined to be:

$$k_x = -\gamma G_x t_x \quad \text{(Equation 30)}.$$

Therefore, we deal with parameters $x$ and $k_x$ in magnetic resonance imaging, not $\omega_x$ and $t$. The proton spin intensity is solved by inverse Fourier Transform to $k$-space signals:

$$\rho = \text{FT}^{-1}\left[S(k_x)\right] = C' \int S(k_x) \, e^{ik_x x} \, dk_x \quad \text{(Equation 31)}.$$

where $C'$ is a weighing constant related to the principal magnetic field and proton relaxation. Above principles can be extended to 2-dimensional and 3-dimensional magnetic resonance imaging. Above illustrations followed up definition of the $k$ parameter, which was initiated first in the world for theory and applications of $k$-space in a patent presented in 1979 by GE limited of USA ("Moving Gradient Zeugmatography", USA patent No.4307343, approved date December 22 of 1981). Actually, the *k*-space closely connects to traditional concepts of $\omega_x$ and time *t*. Particularly, a readout value of *k*-space is composed of an in-phase real signal reading *I* and an orthogonal imaginary signal reading *Q*:

$$k_{x,y} = I + iQ, \qquad \text{(Equation 32).}$$

The signal readouts of magnetic resonance imaging allow to regard the gradient frequency parameters $k_{x,y}$ and location parameters *x*&*y* as a routine time domain signal with intensity *K*.

Magnetic resonance imaging based on superimpose Fourier Transform can be implemented as following procedures to obtain superimpose peak shapes of magnetic resonance imaging:

Step S1: a *k*-space time (0 to *T*) signal of magnetic resonance imaging is:

$$f(t) = 2\pi K \left[\cos(\omega_0 t) + i \sin(\omega_0 t)\right] \qquad 0 \leq t \leq T \quad \text{(Equation 33),}$$

where $\omega_0$ is alternatively a magnetic resonance gradient frequency with intensity *K*.

Step S2: the signal acquired in step S1 is operated by Fourier Transform to get basic absorption, dispersion and magnitude peak shapes of Fourier Transform. They are sampling discretely to produce discrete basic absorption, dispersion and magnitude peak shapes, respectively;

Step S3: The peak shapes obtained in step S2 is superimposed through a superimpose function to obtain superimposed absorption, dispersion and/or magnitude peak shapes by superimpose Fourier Transform. They are sampling discretely to produce discrete absorption, dispersion and magnitude superimposed peak shapes, respectively;

Step S4: A corresponding magnetic resonance image is obtained from the above superimposed peak shapes.

Further in this exemplary embodiment, above time domain signal obtained in step S1 produces three classical peak shapes by current Fourier Transform.

(1) A basic absorption peak shape of Fourier Transform as shown in FIG. **32,** its mathematic expression is a well-known function sinc:

$$A(\omega) = K \frac{\sin\left[(\omega - \omega_0)T\right]}{\omega - \omega_0} \qquad \text{(Equation 34).}$$

For *N* of composed nuclear spin frequencies, the angular frequencies are expressed by series $\omega = 2m\pi/T$ and $\omega_0 = 2n\pi/T$, where m and n = 0, 1, 2, $\cdots\cdots$, N-1, its discrete basic absorption peak shape is:

$$A(\omega) = KT \left\{\frac{\sin\left[2\pi(m - n)\right]}{2\pi(m - n)}\right\} \qquad \text{(Equation 34.1).}$$

(2) A basic dispersion peak shape of Fourier Transform is shown in FIG. 35,

$$B(\omega) = K \frac{1 - \cos\left[(\omega - \omega_0)T\right]}{\omega - \omega_0} = KT \frac{\sin^2\left[(\omega - \omega_0)T/2\right]}{(\omega - \omega_0)T/2} \qquad \text{(Equation 35).}$$

The corresponding discrete basic dispersion peak shape is:

$$B(\omega) = KT \left\{\frac{\sin^2\left[\pi(m - n)\right]}{\pi(m - n)}\right\} \qquad \text{(Equation 35.1).}$$

(3) The basic magnitude peak shape (also termed as absolute value peak shape) of Fourier Transform is shown in FIG. **37,**

$$C(\omega) = \sqrt{[A(\omega)]^2 + [B(\omega)]^2} = K \left| \frac{2\sin[(\omega - \omega_0)T/2]}{\omega - \omega_0} \right| \qquad \text{(Equation 36)}.$$

The corresponding discrete basic magnitude peak shape is:

$$C(\omega) = KT \left| \frac{\sin[\pi(m - n)]}{\pi(m - n)} \right| \qquad \text{(Equation 36.1)}.$$

Further in this exemplary embodiment, a pair of superimpose functions for implementation of superimpose Fourier Transform are initiated as below:

$$\text{Simp}_1(x) = 1 + \frac{x}{|x|} = \begin{cases} 0 & x < 0 \\ 2 & x \geq 0 \end{cases} \qquad \text{(Equation 37.1)};$$

$$\text{Simp}_2(x) = 1 - \frac{x}{|x|} = \begin{cases} 2 & x < 0 \\ 0 & x \geq 0 \end{cases} \qquad \text{(Equation 37.2)}.$$

The above superimpose functions equal to superpose half part of a symmetric or antisymmetric function to another half of itself, either right-superimpose or left-superimpose. The function $\text{Simp}_1$ is defined as right-superimpose; the function $\text{Simp}_2$ with minus is left-superimpose. It has the same superimpose effect to replace $x/|x|$ with $|x|/x$ in the two superimpose functions.

Further, a special function commonly seen in Fourier Transform is Sign function:

$$\text{sgn}(x) = \begin{cases} -1, & x < 0 \\ 1, & x \geq 0 \end{cases} \qquad \text{(Equation 38)}.$$

The superimpose functions have following relationship with the Sign function:

$$\text{Simp}(x) = 1 \pm \text{sgn}(x) \qquad \text{(Equation 39)}.$$

In real field, the superimpose function with plus (+) is exactly two times of another well-known function, Step function $H(x)$:

$$\text{Simp}_1(x) = 2\,H(x) \qquad \text{(Equation 40)}.$$

Definition of Step function is:

$$H(x) = \begin{cases} 0, & x < 0 \\ 1, & x \geq 0 \end{cases} \qquad \text{(Equation 41)}.$$

Further in this exemplary embodiment, with substituting independent variable $x = \omega - \omega_0$ in the superimpose functions, three new types of the basic peak shapes are generated by the above superimpose Fourier Transform.

(1) Fourier Transform superimposed absorption peak shapes as shown in FIG. **33** and FIG. **34,**

$$A^{'}(\omega) = K \left\{ \frac{\sin\left[(\omega - \omega_0)T\right]}{\omega - \omega_0} \pm \frac{\sin\left[(\omega - \omega_0)T\right]}{|\omega - \omega_0|} \right\}$$

$$= \left(1 \pm \frac{\omega - \omega_0}{|\omega - \omega_0|}\right) A(\omega)$$
(Equation 42).

Its corresponding discrete superimposed absorption peak shape is:

$$A'(\omega) = \left(1 \pm \frac{m - n}{|m - n|}\right) KT \left\{ \frac{\sin[2\pi(m - n)]}{2\pi(m - n)} \right\}$$
(Equation 42.1).

(2) Fourier Transform superimposed dispersion peak shape,

$$B'(\omega) = \left(1 \pm \frac{\omega - \omega_0}{|\omega - \omega_0|}\right) B(\omega)$$
(Equation 43).

FIG. 36 is a schematic drawing of right-superimpose dispersion peak shape. Its corresponding discrete superimposed dispersion peak shape is:

$$B'(\omega) = \left(1 \pm \frac{m - n}{|m - n|}\right) KT \left\{ \frac{\sin^2[\pi(m - n)]}{\pi(m - n)} \right\}$$
(Equation 43.1).

(3) Fourier Transform superimposed magnitude peak shape,

$$C'(\omega) = \left(1 \pm \frac{\omega - \omega_0}{|\omega - \omega_0|}\right) C(\omega)$$
(Equation 44).

FIG. **38** is a schematic drawing of right-superimpose Fourier Transform magnitude peak shape.
Its corresponding discrete superimposed magnitude peak shape is:

$$C'(\omega) = \left(1 \pm \frac{m - n}{|m - n|}\right) KT \left| \frac{\sin[\pi(m - n)]}{\pi(m - n)} \right|$$
(Equation 44.1).

Further in this exemplary embodiment, superimpose Fourier Transform for magnetic resonance imaging is a fundamental improvement to current theory and technique of Fourier Transform, and initiates a mathematic approach to superimpose the basic peak shapes of Fourier Transform, including absorption, dispersion and magnitude (or power) peak shapes. The superimpose operations based on symmetric characteristics of these peak shapes achieved 100% improvement of signal resolution, intensity and signal-to-noise-ratio. FIG. **32** shows an absorption peak of Fourier Transform produced from a cosine signal of angular frequency $\omega_0$, which is of axial symmetry. After right-superimpose, its peak width is narrowed by half, peak height becomes double, and interference peaks (Gibbs phenomenon) at left side of the flipping axis (former symmetric axis) are demolished to zero as shown in FIG. **33.** It has the same effect to make left-superimpose for the absorption peak as shown in FIG. **34.** FIG. **35** is a dispersion peak shape by Fourier Transform from the same signal. It is of center symmetry and can be superimposed by rotation of 180°. Because the magnitude peak is given from square root of absorption peak square plus dispersion peak square, its peak shape shown in FIG. **37** is of axial symmetry as well. The superimpose method provided in this embodiment is suitable to the dispersion and magnitude peak shapes accordingly. This technique changes common concept of spectral peak shape, and invent a way of asymmetric peak shape. It ensures no information loss and enhances quality of the signal analyses. The biggest drawback of Fourier Transform is the harmonic sidelobes around its principal peak as shown in FIG. **32**, FIG. **32** and FIG. **34**, commonly termed as Gibbs phenomenon. They are usually suppressed by an apodization function. Our new technology can demolish Gibbs effect in one side of the signal peak, but the another side should apply apodization to smooth the peak.

Further in this exemplary embodiment, for a nuclear magnetic resonance gradient signal measured in time duration of $T$ where signal intensity is $K$ ($K$ = arbitrary real number) and frequency is $\omega_0$, we compare key technical parameters between current Fourier Transform theory and new Fourier Transform theory in Table **4** and Table **5** by means of numerical calculation. Height of the three peak shapes are all doubled and their peak widths are narrowed by half. Thus, resolution of the cosine signal is increased doubly.

Table **6** The key parameters of current Fourier Transform

| Peak shape | Peak height | Half peak width | Full peak width |
|---|---|---|---|
| Absorption | $KT_{x,y}$ | $\dfrac{3.7910}{T_{x,y}}$ | $\dfrac{2\pi}{T_{x,y}}$ |
| Dispersion | $\pm 0.7246 KT_{x,y}$ | $\dfrac{8.3488}{T_{x,y}}$ | $\dfrac{4\pi}{T_{x,y}}$ |
| Magnitude (absolute value) | $KT_{x,y}$ | $\dfrac{7.5820}{T_{x,y}}$ | $\dfrac{4\pi}{T_{x,y}}$ |

Table **7** The key parameters of superimpose Fourier Transform

| Peak shape | Peak height | Half peak width | Full peak width |
|---|---|---|---|
| Absorption | $2KT_{x,y}$ | $\dfrac{1.8955}{T_{x,y}}$ | $\dfrac{\pi}{T_{x,y}}$ |
| dispersion | $1.4492 KT_{x,y}$ | $\dfrac{3.4138}{T_{x,y}}$ | $\dfrac{2\pi}{T_{x,y}}$ |
| Magnitude (absolute value) | $2KT_{x,y}$ | $\dfrac{3.7910}{T_{x,y}}$ | $\dfrac{2\pi}{T_{x,y}}$ |

Further in this exemplary embodiment, the parameters shown in Table **6** and Table 7 indicate that spatial resolution of magnetic resonance imaging greatly depends on magnetic field gradients and sampling time. Imaging medical examination is carried out within magnetic resonance gradient coils. As long as if a magnetic resonance receiver has sufficient sensitivity to distinguish gradient variations, the imaging resolution depends on the sampling time which determines, the peak width after Fourier Transform. Take 4 adjacent squares labelled with "11", "12", "21" and "22" in FIG. **39** to represent some portion of a living body in a magnetic resonance imaging. Proton gradient magnetic resonance signals (no consideration of free induction decay) are:

"11":   $K_{11}[\cos(\omega_{11}t) + i\,\sin(\omega_{11}t)]$;

"12":   $K_{12}[\cos(\omega_{12}t) + i\,\sin(\omega_{12}t)]$;

"21": $K_{21}[\cos(\omega_{21}t)+i\sin(\omega_{21}t)]$;

"22": $K_{22}[\cos(\omega_{22}t)+i\sin(\omega_{22}t)]$,

where $K_{11}$, $K_{12}$, $K_{21}$ and $K_{22}$ are signal intensity in each square, respectively; $\omega_{11}$, $\omega_{12}$, $\omega_{21}$ and $\omega_{22}$ are gradient frequency in each square. When sampling time is not sufficient to have enough narrow peak width after current Fourier Transform, the magnitude peak shapes (thin line) corresponding to gradient frequencies $\omega_{11}$ and $\omega_{12}$ will merge into one peak (thick line) in horizontal imaging scanning as shown in FIG. **40.** Similar result could be to vertical imaging scanning. Therefore, poor spatial resolutions would lead these four small squares (pixels) to mix into one component. Because a nuclear magnetic resonance time signal always has free induction decay, the peak width after Fourier Transform actually is much wider than theoretical values of the three basic peak shapes listed in Table **6.** The superimpose operation initiated in this embodiment is able to reduce half peak width practically.

In this exemplary embodiment, the superimpose operation to the above three basic peak shapes of Fourier Transform can be implemented by following several approaches, but no limitation to them. Because the magnitude peak shape is usually used in Fourier Transform magnetic resonance imaging, take magnitude peak shape as an instant in below implementations of superimpose Fourier Transform.

(1) Current magnetic resonance imaging always set in advance magnetic field gradient frequency (or gradient phase) and sampling pixels to perform Fourier Transform. As long as the sampling points are big enough, signal frequency will not be distorted. There is no necessary to preset any extra parameter according to above equation of Fourier Transform magnitude peak shape, including Equation **42,** Equation **43** or Equation **44.** The raw data collected in $k$-space as shown in FIG. **39** already contain information of signal intensities and gradient frequencies. In order to cover every proton gradient magnetic resonance response, we can implement superimpose operation together for all of individual frequency $\omega_0$ components. This way would consume N times of superimpose operation time to N of $\omega_0$ components. Nevertheless, the superimpose operation can be optimized by properly grouping the frequency components. According to practical situation and goals, the frequency signals are grouped by 2 components, 4 components or 8 components etc. in each individual group, and then implemented respectively by superimpose Fourier Transform, such that the operation time is reduced effectively. Particularly, because speed of modern computer becomes faster and faster, the optimization of grouping frequency components would not cost much time in superimpose operation. FIG. **41** is an overlapping schematic diagram for a group of 10 magnetic resonance frequencies (in grey thin line) with equal distribution implemented by current Fourier Transform which were overlapped peak-to-peak in varying degree due to gradient magnetic field; after implemented left-superimpose Fourier Transform initiated in this embodiment, the 10 peaks were separated completely (in thick solid line).

(2) According to demand of current Fourier Transform, a harmonic signal $f(t)$ must be discretized and digitally sampled. If there are $N$ of signal samples, it should have a set of discrete signal points $f(0)$, $f(1)$, $f(2)$, $\cdots f(k)$, $\cdots$, $f(N-1)$. $N$ of the data $F(0)$, $F(1)$, $F(2)$, $\cdots F(k)$, $\cdots$, $F(N-1)$ are acquired by discrete Fourier Transform, which is expressed by a matrix:

$$
\begin{pmatrix}
F(0) \\
F(1) \\
F(2) \\
\vdots \\
F(k) \\
\vdots \\
F(N-1)
\end{pmatrix}
=
\begin{pmatrix}
1 & 1 & 1 & \cdots & 1 \\
1 & W & W^2 & \cdots & W^{N-1} \\
1 & W^2 & W^4 & \cdots & W^{N-2} \\
\vdots & \vdots & \vdots & \ddots & \vdots \\
1 & W^k & W^{2k} & \cdots & W^{N-k} \\
\vdots & \vdots & \vdots & \ddots & \vdots \\
1 & W^{N-1} & W^{N-2} & \cdots & W
\end{pmatrix}
\begin{pmatrix}
f(0) \\
f(1) \\
f(2) \\
\vdots \\
f(k) \\
\vdots \\
f(N-1)
\end{pmatrix}
\quad \text{(Equation 45),}
$$

where factor $W = exp(-i2\pi/N)$ in the $N{\times}N$ of Fourier Transform matrix.

In this exemplary embodiment, above equation is simply multiplied by a specific diagonal superimpose matrix as below to implement the superimpose operation:

$$
\begin{pmatrix} F(0) \\ F(1) \\ F(2) \\ \vdots \\ F(k) \\ \vdots \\ F(N-1) \end{pmatrix} = \begin{pmatrix} 1 & 1 & 1 & 1 & \cdots & 1 \\ 1 & W & W^2 & W^3 & \cdots & W^{N-1} \\ 1 & W^2 & W^4 & W^6 & \cdots & W^{N-2} \\ \vdots & \vdots & \vdots & \vdots & \ddots & \vdots \\ 1 & W^k & W^{2k} & W^{3k} & \cdots & W^{N-k} \\ \vdots & \vdots & \vdots & \vdots & \ddots & \vdots \\ 1 & W^{N-1} & W^{N-2} & W^{N-3} & \cdots & W \end{pmatrix} \begin{pmatrix} 2(0) & 0 & 0 & 0 & \cdots & 0 \\ 0 & 2(0) & 0 & 0 & \cdots & 0 \\ 0 & 0 & 2(0) & 0 & \cdots & 0 \\ \vdots & \vdots & \vdots & \vdots & \ddots & \vdots \\ 0 & 0 & 0 & 0 & \cdots & 0 \\ \vdots & \vdots & \vdots & \vdots & \ddots & \vdots \\ 0 & 0 & 0 & 0 & \cdots & 2(0) \end{pmatrix} \begin{pmatrix} f(0) \\ f(1) \\ f(2) \\ \vdots \\ f(k) \\ \vdots \\ f(N-1) \end{pmatrix}
$$ (Equation 46).

Further, we can scan row-to-row, or $\Delta N$-row-to $\Delta N$-row for a desired resolution $\Delta N$ to determine the diagonal matrix elements to be 2 or 0, or a small number close to zero. Since pixel numbers of magnetic resonance imaging is based on computer binary system, take arrangement mode of $2\cdots2, 0\cdots0, 2\cdots2, 0\cdots0, \cdots\cdots$ in the diagonal matrix elements to implement left-superimpose as below Equation **46.1**:

$$
\begin{pmatrix} 2 & 0 & 0 & 0 & 0 & \cdots & 0 \\ 0 & 0 & 0 & 0 & 0 & \cdots & 0 \\ 0 & 0 & 2 & 0 & 0 & \cdots & 0 \\ 0 & 0 & 0 & 0 & \vdots & \ddots & \vdots \\ 0 & 0 & 0 & 0 & 2 & \cdots & 0 \\ \vdots & \vdots & \vdots & \vdots & \vdots & \ddots & \vdots \\ 0 & 0 & 0 & 0 & 0 & \cdots & 0 \end{pmatrix}
$$ (Equation 46.1).

Also mode of $0\cdots0, 2\cdots2, 0\cdots0, 2\cdots2, \cdots\cdots$ in the diagonal matrix elements is taken to implement right-superimpose:

$$
\begin{pmatrix} 0 & 0 & 0 & 0 & 0 & \cdots & 0 \\ 0 & 2 & 0 & 0 & 0 & \cdots & 0 \\ 0 & 0 & 0 & 0 & 0 & \cdots & 0 \\ 0 & 0 & 0 & 2 & \vdots & \ddots & \vdots \\ 0 & 0 & 0 & 0 & 0 & \cdots & 0 \\ \vdots & \vdots & \vdots & \vdots & \vdots & \ddots & \vdots \\ 0 & 0 & 0 & 0 & 0 & \cdots & 2 \end{pmatrix}
$$ (Equation 46.2).

The 10 component peaks of gradient magnetic resonance in FIG. **41** are identified and separated completely by left-superimpose Fourier Transform matrix (Equation **46.1**) as shown in FIG. **42**.

Further, it provides theoretical base for imaging calibration using grey histogram in magnetic resonance imaging. FIG. **43** and FIG. **44** are raw $k$-space graph and image of an artificial membrane, which obtained from Siemens Verio 3T Tim magnetic resonance imaging equipped with a superconductive magnetic field of 3 teslas. Main operating parameters are: spin echo pulse sequence, median sagittal section, slice thickness 4.0mm, dwell time 15.6μs, pulse repetition time 600ms, echo time 6ms, pixel bandwidth 250Hz, and 512X512 pixels. FIG. **45** is a comparison image by using a diagonal superimpose matrix for grey-scale enhance, in which obviously imaging contrast was enhanced. Further in this exemplary embodiment, since there is no relevance between scanning of row-to-row in the diagonal matrix and the rows in Fourier Transform matrix, Fast Fourier Transform (FFT) can be executed with superimpose synchronously. But, Fast Fourier Transform requires using form of square matrix.

(3) From the two superimpose functions initiated in Equation **37.1** and Equation **37.2.**: adjacent harmonic signals can be superimposed for the front peak by left (or right) superimpose and for the back peak by right (or left) superimpose synchronously. As shown in FIG. **46,** resolution of two partially overlapping peaks (in dash line) can be increased as much as 4 times of that by current Fourier Transform, where superimpose effect is indicated by solid line.

The imaging signals of the artificial membrane in FIG. **44** are reprocessed by the superimpose Fourier Transform and extension of double imaging pixels. A more clear image was obtained with a spatial resolution of pixels 1024X1024 as shown in FIG. **47**.

Further, the technique can be extended to handle the signals with free induction decay and phase shift. Because the free induction decay and phase shift are in exponential forms, these exponential components are actually equivalent to apodization functions multiplied to the signals. Their expressions of the corresponding peak shapes remain symmetric superimpose.

Above are preferred embodiments of the invention, any modification made in accordance with the technical scheme of the invention, and the function produced by the invention does not exceed the scope of the technical proposals in this invention, all belong to the scope of protection of this invention.

**Claims**

1.    A superimposed Fourier Transform method to spectroscopic and imaging applications and its character is: the raw time signals are acquired by various spectrometric detectors. The acquired data are processed by Fourier Transform with a superimposed function to superimpose the transformed peak shapes. Then the superimposed signals construct final spectral/imaging results.

2.    A superimposed Fourier Transform spectroscopic and imaging method according to claim 1, wherein a Fourier Transform Infrared Spectroscopy can be obtained by superimposed Fourier Transform. Infrared light generated from an infrared laser source passes an interferometer and sample chamber. The infrared interferogram is measured on an infrared detector. Its infrared interferogram is sampling by a computer unit. Perform superimposed Fourier Transform to the sampled interferogram by the superimposing functions for individual infrared peaks to obtain infrared percentage transmittance and processed infrared spectrum is shown by a display unit.

3.    A superimposed Fourier Transform spectroscopic and imaging method according to claim 2, wherein said a sampled infrared interferogram signal is basically to be:

$$f(t) = 2\pi K \cos(\omega_0 t) \qquad 0 \le t \le T,$$

where $K$ is intensity of a signal, $T$ sampling period for a cosine signal $K\cos(\omega_0 t)$ with frequency $\omega_0$.
Its basic absorption peak shape after Fourier Transform for the infrared interferogram signal is:

$$A(\omega) = K \frac{\sin[(\omega - \omega_0)T]}{\omega - \omega_0} \; ;$$

As an infrared signal contains N of frequencies, the angular frequencies are expressed as series $\omega = 2m\pi/T$ and $\omega_0 = 2n\pi/T$, where m and n = 0, 1, 2, $\cdots \cdots$, N-1, its corresponding discrete absorption peak shape is:

$$A(\omega) = KT \left\{ \frac{\sin[2\pi(m - n)]}{2\pi(m - n)} \right\} .$$

The basic dispersion peak shape of Fourier Transform is:

$$B(\omega) = K \frac{1 - \cos[(\omega - \omega_0)T]}{\omega - \omega_0} = KT \frac{\sin^2[(\omega - \omega_0)T/2]}{(\omega - \omega_0)T/2} \; ;$$

Its discrete dispersion peak shape is:

$$B(\omega) = KT \left\{ \frac{\sin^2[\pi(m-n)]}{\pi(m-n)} \right\}$$ .

The basic magnitude peak shape of Fourier Transform is:

$$C(\omega) = \sqrt{[A(\omega)]^2 + [B(\omega)]^2} = K \left| \frac{2\sin[(\omega - \omega_0)T/2]}{\omega - \omega_0} \right|$$ ;

Its discrete magnitude peak shape is:

$$C(\omega) = KT \left| \frac{\sin[\pi(m-n)]}{\pi(m-n)} \right|$$ .

Define superimpose functions as below:

$$\mathrm{Simp}_1(x) = 1 + \frac{x}{|x|} = \left\{ \begin{array}{ll} 0 & x < 0 \\ 2 & x \geq 0 \end{array} \right.$$

$$\mathrm{Simp}_2(x) = 1 - \frac{x}{|x|} = \left\{ \begin{array}{ll} 2 & x < 0 \\ 0 & x \geq 0 \end{array} \right.$$ .

Dedicate the superimpose function $\mathrm{Simp}_1$ with plus sign as right-side superimpose function and the one with minus sign as left-side superimpose function.

With substituting the independent variance $x = \omega - \omega_0$ **Hata! Başvuru kaynağı bulunamadi.** in the superimpose functions, the above infrared interferogram signal is superimposed by the superimpose functions.
Absorption peak shape via the superimposed Fourier Transform is:

$$A'(\omega) = K \left\{ \frac{\sin[(\omega - \omega_0)T]}{\omega - \omega_0} \pm \frac{\sin[(\omega - \omega_0)T]}{|\omega - \omega_0|} \right\}$$

$$= \left( 1 \pm \frac{\omega - \omega_0}{|\omega - \omega_0|} \right) A(\omega)$$ ;

Its corresponding discrete absorption peak shape is:

$$A'(\omega) = \left( 1 \pm \frac{m-n}{|m-n|} \right) KT \left\{ \frac{\sin[2\pi(m-n)]}{2\pi(m-n)} \right\}$$ .

Dispersion peak shape via the superimpose Fourier Transform is:

$$B'(\omega) = \left( 1 \pm \frac{\omega - \omega_0}{|\omega - \omega_0|} \right) B(\omega)$$ ;

Its corresponding discrete dispersion peak shape is:

$$B'(\omega) = \left(1 \pm \frac{m-n}{|m-n|}\right) KT \left\{\frac{\sin^2[\pi(m-n)]}{\pi(m-n)}\right\}.$$

Magnitude peak shape via the superimpose Fourier Transform is:

$$C'(\omega) = \left(1 \pm \frac{\omega - \omega_0}{|\omega - \omega_0|}\right) C(\omega) \; ;$$

Its corresponding discrete magnitude peak shape is:

$$C'(\omega) = \left(1 \pm \frac{m-n}{|m-n|}\right) KT \left|\frac{\sin[\pi(m-n)]}{\pi(m-n)}\right|.$$

4. The superimpose Fourier Transform method applied to spectroscopy and imaging according to claim 3, wherein said the superimposed peak shape should also include:
   After the infrared interferogram is acquired completely, reconstitute the superimposed spectral peaks with regard to their symmetric axes and peak widths at base individually. Apply phase correction and Gibbs apodization function to them, use deconvolution algorithm for the absorption, dispersion or magnitude peak shapes of the Fourier Transform, and then implement peak superimpose with the superimpose functions.

5. The superimpose Fourier Transform method applied to spectroscopy and imaging according to claim 3, wherein said the superimposed peak shape should further include:
   Select appropriate sampling points and resolution to group sample frequencies $\omega_0$, perform peak superimpose with the superimpose functions for Fourier Transform absorption, dispersion or magnitude peak shapes in each group.

6. The superimpose Fourier Transform method applied to spectroscopy and imaging according to claim 3, wherein said superimposes peak shape should further include:
   The infrared interferogram $f(t)$ is discretized and digitally sampled. If there are $N$ of samples, it should have a set of discrete signal points $f(0)$, $f(1)$, $f(2)$, $\cdots$, $f(k)$, $\cdots$, $f(N-1)$. $N$ of the data $F(0)$, $F(1)$, $F(2)$, $\cdot F(k)$, $\cdots$, $F(N-1)$ are acquired by discrete Fourier Transform to get following Fourier Transform matrix:

$$\begin{pmatrix} F(0) \\ F(1) \\ F(2) \\ \vdots \\ F(k) \\ \vdots \\ F(N-1) \end{pmatrix} = \begin{pmatrix} 1 & 1 & 1 & \cdots & 1 \\ 1 & W & W^2 & \cdots & W^{N-1} \\ 1 & W^2 & W^4 & \cdots & W^{N-2} \\ \vdots & \vdots & \vdots & \ddots & \vdots \\ 1 & W^k & W^{2k} & & W^{N-k} \\ \vdots & \vdots & \vdots & \ddots & \vdots \\ 1 & W^{N-1} & W^{N-2} & \cdots & W \end{pmatrix} \begin{pmatrix} f(0) \\ f(1) \\ f(2) \\ \vdots \\ f(k) \\ \vdots \\ f(N-1) \end{pmatrix}.$$

where factor $W = exp(-i2\pi/N)$ in the $N \times N$ of Fourier Transform matrix.
By inserting a specific diagonal superimpose matrix in above formula, a superimpose Fourier Transform matrix is obtained for superimpose operation:

$$\begin{pmatrix} F(0) \\ F(1) \\ F(2) \\ \vdots \\ F(k) \\ \vdots \\ F(N-1) \end{pmatrix} = \begin{pmatrix} 1 & 1 & 1 & 1 & \cdots & 1 \\ 1 & W & W^2 & W^3 & \cdots & W^{N-1} \\ 1 & W^2 & W^4 & W^6 & \cdots & W^{N-2} \\ \vdots & \vdots & \vdots & \vdots & \ddots & \vdots \\ 1 & W^k & W^{2k} & W^{3k} & \cdots & W^{N-k} \\ \vdots & \vdots & \vdots & \vdots & \ddots & \vdots \\ 1 & W^{N-1} & W^{N-2} & W^{N-3} & \cdots & W \end{pmatrix} \begin{pmatrix} 2(0) & 0 & 0 & 0 & \cdots & 0 \\ 0 & 2(0) & 0 & 0 & \cdots & 0 \\ 0 & 0 & 2(0) & 0 & \cdots & 0 \\ \vdots & \vdots & \vdots & \vdots & \ddots & \vdots \\ 0 & 0 & 0 & 0 & \cdots & 0 \\ \vdots & \vdots & \vdots & \vdots & \ddots & \vdots \\ 0 & 0 & 0 & 0 & \cdots & 2(0) \end{pmatrix} \begin{pmatrix} f(0) \\ f(1) \\ f(2) \\ \vdots \\ f(k) \\ \vdots \\ f(N-1) \end{pmatrix}$$
.

7. The superimpose Fourier Transform method applied to spectroscopy and imaging according to claim 6, wherein was **characterized by** scanning row-to-row, or $\Delta N$-row-to $\Delta N$-row for a desired resolution $\Delta N$. The corresponding slop variation is compared to determine the diagonal elements of the inserted matrix to be 2 or 0.

8. The superimpose Fourier Transform method applied to spectroscopy and imaging according to claim 7, wherein was characterized to take value of 2 for the diagonal matrix element when the slope of front point is positive in right-superimpose operation; take value of 0 for the diagonal matrix element as slope of the front point is negative or 0. It is opposite in left-superimpose operation.

9. The superimpose Fourier Transform method applied to spectroscopy and imaging according to claim 7, wherein was characterized to take the diagonal matrix element to be 2 or 0 relying on whether each peak value is increased, steady or decreased by comparing with scanned front point.

10. The superimpose Fourier Transform method applied to spectroscopy and imaging according to claim 3, wherein said the superimposed peak shape should further include: adjacent harmonic signals can be superimposed for the front peak by left (or right) superimpose and for the back peak by right (or left) superimpose synchronously.

11. The superimpose Fourier Transform method applied to spectroscopy and imaging according to claim 2, wherein was **characterized by** using Helium-Neon laser with emitting wavelength 632.8 nm as infrared light source. The interferometer in the embodiment was double-sided optical path with 3295 of retardation steps, resolution of 16 cm$^{-1}$, and 709 of wavenumber readings with regard to 3.85 cm$^{-1}$ of interval displacement.

12. The superimpose Fourier Transform method applied to spectroscopy and imaging according to claim 11, wherein was **characterized by** using thermal radiation, gaseous charge and laser infrared light sources with wavelength range from 0.78 nm to 1000 nm. Arms of the interferometer move in back and forth directions, and can be designed to high resolution scope of 4cm$^{-1}$ to 0.07cm$^{-1}$.

13. The superimpose Fourier Transform method applied to spectroscopy and imaging according to claim 2, wherein is applicable to acquire infrared transmittance of Raman spectrometer, near infrared spectrometer and far infrared spectrometer.

14. The superimpose Fourier Transform method applied to spectroscopy and imaging according to claims 2 to 13, wherein was characterized to handle free induction decay and phase shift in signal frequencies.

15. The superimpose Fourier Transform method applied to spectroscopy and imaging according to claim 1, wherein was characterized to further include nuclear magnetic resonance spectrometry based on superimpose Fourier Transform to superimpose peak shape of nuclear magnetic resonance. It can be realized by following procedures:

Step S1: a time domain signal of nuclear magnetic resonance is acquired from dual detection channels of a nuclear magnetic resonance apparatus;
Step S2: the time domain signal of nuclear magnetic resonance acquired in step S1 is operated by Fourier Transform to get basic absorption, dispersion and magnitude peak shapes of Fourier Transform. They are sampling discretely to produce discrete basic absorption, dispersion and magnitude peak shapes, respectively;
Step S3: the peak shapes obtained in step S2 is superimposed through a suitable superimpose function to obtain superimposed absorption, dispersion and/or magnitude peak shapes of superimpose Fourier Transform. They are sampled discretely to produce discrete absorption, dispersion and magnitude superimposed peak shapes, respectively;

Step S4: a nuclear magnetic resonance spectrum is acquired after the signal has been processed with above superimposed peak shapes.

16. The superimpose Fourier Transform method applied to spectroscopy and imaging according to claim 15, wherein was **characterized by** using below superimpose functions in step S3:

$$\mathrm{Simp}_1(x) = 1 + \frac{x}{|x|} = \left\{ \begin{array}{ll} 0 & x < 0 \\ 2 & x \geq 0 \end{array} \right.$$

$$\mathrm{Simp}_2(x) = 1 - \frac{x}{|x|} = \left\{ \begin{array}{ll} 2 & x < 0 \\ 0 & x \geq 0 \end{array} \right. .$$

17. The superimpose Fourier Transform method applied to spectroscopy and imaging according to claim 16, wherein was characterized to analyze a time $t$ domain (0 to $T$) signal from dual detection channels of nuclear magnetic resonance spectrometer:

$$f(t) = 2\pi K\, e^{-t/\tau} [\cos(\omega_0 t) + i\,\sin(\omega_0 t)] \qquad 0 \leq t \leq T,$$

where $\omega_0$ is nuclear magnetic resonance frequency of a nucleus with intensity $K$ and free induction decay coefficient $\tau$. The basic absorption peak shape of Fourier Transform in the above step 2 is:

$$A(\omega) = 2K\frac{\sin\left[(\omega - \omega_0)T\right]}{\omega - \omega_0} .$$

For $N$ of composed nuclear spin frequencies, the angular frequencies are expressed by series $\omega = 2m\pi/T$ and $\omega_0 = 2n\pi/T$, where m and n = 0, 1, 2, $\cdots\cdots$, N-1, its discrete basic absorption peak shape is:

$$A(\omega) = 2KT\left\{\frac{\sin\left[2\pi(m-n)\right]}{2\pi(m-n)}\right\};$$

With substituting the independent variance $x = \omega - \omega_0$ in the superimpose functions for the step 3 and superimposing the peak shape by the superimpose function, a superimposed absorption peak shape from the superimpose Fourier Transform is obtained:

$$A'(\omega) = 2K\left\{\frac{\sin\left[(\omega - \omega_0)T\right]}{\omega - \omega_0} \pm \frac{\sin\left[(\omega - \omega_0)T\right]}{|\omega - \omega_0|}\right\}$$

$$= \left(1 \pm \frac{\omega - \omega_0}{|\omega - \omega_0|}\right) A(\omega);$$

A corresponding discrete superimposed absorption peak shape is:

$$A'(\omega) = 2\left(1 \pm \frac{m-n}{|m-n|}\right) KT\left\{\frac{\sin\left[2\pi(m-n)\right]}{2\pi(m-n)}\right\}.$$

18. The superimpose Fourier Transform method applied to spectroscopy and imaging according to claim 15, wherein was **characterized by** detection of a time $t$ domain (0 to $T$) signal of nuclear magnetic resonance in dual channels:

$$f(t) = 2\pi K \, e^{-t/\tau} \left[\cos(\omega_0 t) + i \sin(\omega_0 t)\right] \qquad 0 \leq t \leq T,$$

where $\omega_0$ is nuclear magnetic resonance frequency of a nucleus with intensity $K$ and free induction decay coefficient $\tau$. The basic dispersion peak shape of Fourier Transform in the above step S2 is:

$$B(\omega) = \pm 2K \frac{1 - \cos\left[(\omega - \omega_0)T\right]}{\omega - \omega_0} = \pm KT \frac{\sin^2\left[(\omega - \omega_0)T/2\right]}{(\omega - \omega_0)T/2} \; ;$$

A corresponding discrete basic dispersion peak shape is:

$$B(\omega) = \pm 2KT \left\{ \frac{\sin^2\left[\pi(m - n)\right]}{\pi(m - n)} \right\}.$$

With substituting the $x = \omega - \omega_0$ for the step 3 and superimposing the peak shape by the superimpose function, a superimposed dispersion peak shape from the superimpose Fourier Transform is obtained:

$$B'(\omega) = \left(1 \pm \frac{\omega - \omega_0}{|\omega - \omega_0|}\right) B(\omega).$$

The corresponding discrete superimposed dispersion peak shape is:

$$B'(\omega) = 2\left(1 \pm \frac{m - n}{|m - n|}\right) KT \left\{ \frac{\sin^2\left[\pi(m - n)\right]}{\pi(m - n)} \right\}.$$

19. The superimpose Fourier Transform method applied to spectroscopy and imaging according to claim 15, wherein was **characterized by** detection of a time $t$ domain (0 to $T$) signal of nuclear magnetic resonance in dual channels:

$$f(t) = 2\pi K \, e^{-t/\tau} \left[\cos(\omega_0 t) + i \sin(\omega_0 t)\right] \qquad 0 \leq t \leq T,$$

where $\omega_0$ is nuclear magnetic resonance frequency of a nucleus with intensity $K$ and free induction decay coefficient $\tau$. A basic magnitude peak shape of Fourier Transform in the above step S2 is:

$$C(\omega) = \sqrt{[A(\omega)]^2 + [B(\omega)]^2} = 2K \left| \frac{2\sin\left[(\omega - \omega_0)T/2\right]}{\omega - \omega_0} \right| ;$$

The corresponding discrete basic magnitude peak shape is:

$$C(\omega) = 2KT \left| \frac{\sin\left[\pi(m - n)\right]}{\pi(m - n)} \right| ;$$

With substituting the $x = \omega - \omega_0$ for the step 3 and superimposing the peak shape by the superimpose function, a superimposed magnitude peak shape from the superimpose Fourier Transform is obtained:

$$C'(\omega) = \left(1 \pm \frac{\omega - \omega_0}{|\omega - \omega_0|}\right) C(\omega)$$ .

A corresponding discrete superimposed magnitude peak shape is:

$$C'(\omega) = 2 \left(1 \pm \frac{m - n}{|m - n|}\right) KT \left|\frac{\sin[\pi(m - n)]}{\pi(m - n)}\right|$$ .

20. The superimpose Fourier Transform method applied to spectroscopy and imaging according to claim 15, wherein said the superimposed peak shape should further include in the above step S3:
Select appropriate sampling points and resolution to group sample frequencies $\omega_0$ for the time domain signal of nuclear magnetic resonance, perform peak superimpose with the superimpose functions for the absorption, dispersion or magnitude peak shapes of the Fourier Transform in each group.

21. The superimpose Fourier Transform method applied to spectroscopy and imaging according to claim 15, wherein said the superimposed peak shape should further include:
The harmonic nuclear magnetic resonance time signal $f(t)$ is discretized and digitally sampled. If there are $N$ of samples, it should have a set of discrete signal points $f(0)$, $f(1)$, $f(2)$, $\cdots$, $f(k)$, $\cdots$, $f(N\text{-}1)$. $N$ of the data $F(0)$, $F(1)$, $F(2)$,$\cdot F(k)$, $\cdots$, $F(N\text{-}1)$ are acquired by discrete Fourier Transform to get a following Fourier Transform matrix:

$$\begin{pmatrix} F(0) \\ F(1) \\ F(2) \\ \vdots \\ F(k) \\ \vdots \\ F(N{-}1) \end{pmatrix} = \begin{pmatrix} 1 & 1 & 1 & \cdots & 1 \\ 1 & W & W^2 & \cdots & W^{N-1} \\ 1 & W^2 & W^4 & \cdots & W^{N-2} \\ \vdots & \vdots & \vdots & \ddots & \vdots \\ 1 & W^k & W^{2k} & \cdots & W^{N-k} \\ \vdots & \vdots & \vdots & \ddots & \vdots \\ 1 & W^{N-1} & W^{N-2} & \cdots & W \end{pmatrix} \begin{pmatrix} f(0) \\ f(1) \\ f(2) \\ \vdots \\ f(k) \\ \vdots \\ f(N{-}1) \end{pmatrix}$$ ,

where the factor $W = exp(\text{-}i2\pi/N)$ in the $N \times N$ of Fourier Transform matrix.
By inserting a specific diagonal superimpose matrix in above formula, a superimpose Fourier Transform matrix is obtained for superimpose operation:

$$\begin{pmatrix} F(0) \\ F(1) \\ F(2) \\ \vdots \\ F(k) \\ \vdots \\ F(N{-}1) \end{pmatrix} = \begin{pmatrix} 1 & 1 & 1 & 1 & \cdots & 1 \\ 1 & W & W^2 & W^3 & \cdots & W^{N-1} \\ 1 & W^2 & W^4 & W^6 & \cdots & W^{N-2} \\ \vdots & \vdots & \vdots & \vdots & \ddots & \vdots \\ 1 & W^k & W^{2k} & W^{3k} & \cdots & W^{N-k} \\ \vdots & \vdots & \vdots & \vdots & \ddots & \vdots \\ 1 & W^{N-1} & W^{N-2} & W^{N-3} & \cdots & W \end{pmatrix} \begin{pmatrix} 2(0) & 0 & 0 & 0 & \cdots & 0 \\ 0 & 2(0) & 0 & 0 & \cdots & 0 \\ 0 & 0 & 2(0) & 0 & \cdots & 0 \\ \vdots & \vdots & \vdots & \vdots & \ddots & \vdots \\ 0 & 0 & 0 & 0 & \cdots & 0 \\ \vdots & \vdots & \vdots & \vdots & \ddots & \vdots \\ 0 & 0 & 0 & 0 & \cdots & 2(0) \end{pmatrix} \begin{pmatrix} f(0) \\ f(1) \\ f(2) \\ \vdots \\ f(k) \\ \vdots \\ f(N{-}1) \end{pmatrix}$$ .

22. The superimpose Fourier Transform method applied to spectroscopy and imaging according to claim 21, wherein was **characterized by** scanning row-to-row, or $\Delta N$-row-to $\Delta N$-row for a desired resolution $\Delta N$. The corresponding slop variation is compared to determine the diagonal elements of the inserted matrix to be 2 or 0.

23. The superimpose Fourier Transform method applied to spectroscopy and imaging according to claim 21, wherein was characterized to set sampling points according to computer binary system. Take arrangement mode of 2$\cdots$2, 0$\cdots$0, 2$\cdots$2, 0$\cdots$0, $\cdots\cdots$ in the diagonal matrix elements to execute left-superimpose operation of the peak shapes;

take mode of 0···0, 2···2, 0···0, 2···2, ······ in the diagonal matrix elements to execute right-superimpose operation of the peak shapes.

24. The superimpose Fourier Transform method applied to spectroscopy and imaging according to claim 15, wherein said the superimposed peak shape should further include: adjacent harmonic signals can be superimposed for the front peak by left or right superimpose and for the back peak by right or left superimpose synchronously.

25. The superimpose Fourier Transform method applied to spectroscopy and imaging according to claim 15, wherein is applicable to acquire frequency spectra of electron paramagnetic resonance spectrometers, ion cyclotron resonance spectrometers and microwave spectrometers.

26. The superimpose Fourier Transform method applied to spectroscopy and imaging according to any item in claims 15 to 25, wherein was characterized to handle the signals containing free induction decay and phase shift in signal frequency.

27. The superimpose Fourier Transform method applied to spectroscopy and imaging according to claim 1, wherein was characterized to further include a magnetic resonance imaging method based on superimpose Fourier Transform to superimpose peak shape of nuclear magnetic resonance. It can be realized by following procedures:

Step S1: a magnetic resonance signal is acquired by a magnetic resonance imaging apparatus;
Step S2: the magnetic resonance signal acquired in step S1 is applied by Fourier Transform to get basic absorption, dispersion and magnitude peak shapes of Fourier Transform. They are sampling discretely to produce discrete basic absorption, dispersion and magnitude peak shapes, respectively;
Step S3: The peak shapes obtained in step S2 are superimposed through a suitable superimpose function to obtain superimposed absorption, dispersion and/or magnitude peak shapes of superimpose Fourier Transform. They are sampling discretely to produce discrete absorption, dispersion and magnitude superimposed peak shapes, respectively;
Step S4: The resulting signals are superimposed to generate magnetic resonance images.

28. The superimpose Fourier Transform method applied to spectroscopy and imaging according to claim 27, wherein was characterized to apply the above step S1. The signal is nuclear magnetic resonance gradient echo signal with a general form $S(t) = I(t)+iQ(t)$, which is composed of real portion in-phase and imaginary portion at orthogonal out-phase detected from dual channels.

29. The superimpose Fourier Transform method applied to spectroscopy and imaging according to claim 27, wherein was characterized to applicable to the above step S4 according to symmetric property of Fourier Transform, the image process in the steps S2 and S3 implemented by inverse Fourier Transform.

30. The superimpose Fourier Transform method applied to spectroscopy and imaging according to claim 27, wherein was **characterized by** using below superimpose functions in step S3:

$$\mathrm{Simp}_1(x) = 1+\frac{x}{|x|} = \left\{ \begin{array}{ll} 0 & x < 0 \\ 2 & x \geq 0 \end{array} \right.$$

$$\mathrm{Simp}_2(x) = 1-\frac{x}{|x|} = \left\{ \begin{array}{ll} 2 & x < 0 \\ 0 & x \geq 0 \end{array} \right. .$$

31. The superimpose Fourier Transform method applied to spectroscopy and imaging according to claim 30, wherein was characterized to analyze a $k$-space signal (acquired time $t$ from 0 to $T$) in the above step S1:

$$f(t) = 2\pi K \left[\cos(\omega_0 t)+i \sin(\omega_0 t)\right] \qquad 0 \leq t \leq T ,$$

where $\omega_0$ is nuclear magnetic resonance frequency of a nucleus with intensity $K$ and free induction decay coefficient $\tau$. The basic absorption peak shape of Fourier Transform in the above step S2 is:

$$A(\omega) = K \frac{\sin\left[(\omega - \omega_0)T\right]}{\omega - \omega_0}.$$

For $N$ of the $k$-space signals, the angular frequencies are expressed by series $\omega = 2m\pi/T$ and $\omega_0 = 2n\pi/T$, where m and n = 0, 1, 2, $\cdots\cdots$, N-1, its discrete basic absorption peak shape is:

$$A(\omega) = KT \left\{ \frac{\sin\left[2\pi(m-n)\right]}{2\pi(m-n)} \right\};$$

With substituting the independent variance $x = \omega - \omega_0$ in the superimpose functions in the step 3 and superimposing the peak shape by the superimpose function, a superimposed absorption peak shape from the superimpose Fourier Transform is obtained:

$$A'(\omega) = K \left\{ \frac{\sin\left[(\omega - \omega_0)T\right]}{\omega - \omega_0} \pm \frac{\sin\left[(\omega - \omega_0)T\right]}{|\omega - \omega_0|} \right\}$$

$$= \left(1 \pm \frac{\omega - \omega_0}{|\omega - \omega_0|}\right) A(\omega)$$

The corresponding discrete superimposed absorption peak shape is:

$$A'(\omega) = \left(1 \pm \frac{m-n}{|m-n|}\right) KT \left\{ \frac{\sin\left[2\pi(m-n)\right]}{2\pi(m-n)} \right\}.$$

32. The superimpose Fourier Transform method applied to spectroscopy and imaging according to claim 30, wherein was characterized to analyze a $k$-space signal (acquired time $t$ from 0 to $T$):

$$f(t) = 2\pi K \left[\cos(\omega_0 t) + i \sin(\omega_0 t)\right] \qquad 0 \le t \le T,$$

where $\omega_0$ is nuclear magnetic resonance frequency of a nucleus with intensity $K$ and free induction decay coefficient $\tau$. The basic dispersion peak shape of Fourier Transform in above step S2 is:

$$B(\omega) = K \frac{1 - \cos\left[(\omega - \omega_0)T\right]}{\omega - \omega_0} = KT \frac{\sin^2\left[(\omega - \omega_0)T/2\right]}{(\omega - \omega_0)T/2};$$

The corresponding discrete dispersion peak shape is:

$$B(\omega) = KT \left\{ \frac{\sin^2\left[\pi(m-n)\right]}{\pi(m-n)} \right\};$$

With substituting $x = \omega - \omega_0$ **Hata! Başvuru kaynağı bulunamadı.** and superimposing the peak shape by the superimpose function in above step S3, a superimposed dispersion peak shape from the superimpose Fourier Transform is obtained:

$$B'(\omega) = \left(1 \pm \frac{\omega - \omega_0}{|\omega - \omega_0|}\right) B(\omega);$$

The corresponding discrete superimposed dispersion peak shape is:

$$B'(\omega) = \left(1 \pm \frac{m - n}{|m - n|}\right) KT \left\{\frac{\sin^2[\pi(m - n)]}{\pi(m - n)}\right\}.$$

**33.** The superimpose Fourier Transform method applied to spectroscopy and imaging according to claim 30, wherein was characterized to analyze a *k*-space signal (acquired time *t* from 0 to *T*):

$$f(t) = 2\pi K \left[\cos(\omega_0 t) + i \sin(\omega_0 t)\right] \qquad 0 \le t \le T,$$

where $\omega_0$ is nuclear magnetic resonance frequency of a nucleus with intensity *K* and free induction decay coefficient $\tau$. The basic magnitude peak shape of Fourier Transform in the above step S2 is:

$$C(\omega) = \sqrt{[A(\omega)]^2 + [B(\omega)]^2} = K \left|\frac{2\sin[(\omega - \omega_0)T/2]}{\omega - \omega_0}\right|;$$

Corresponding discrete superimposed magnitude peak shape is:

$$C(\omega) = KT \left|\frac{\sin[\pi(m - n)]}{\pi(m - n)}\right|;$$

With substituting the independent variance $x = \omega - \omega_0$ in the superimpose functions in the step 3 and superimposing the peak shape by the superimpose function, a superimposed magnitude peak shape from the superimpose Fourier Transform is obtained:

$$C'(\omega) = \left(1 \pm \frac{\omega - \omega_0}{|\omega - \omega_0|}\right) C(\omega);$$

Corresponding discrete superimposed magnitude peak shape is:

$$C'(\omega) = \left(1 \pm \frac{m - n}{|m - n|}\right) KT \left|\frac{\sin[\pi(m - n)]}{\pi(m - n)}\right|.$$

**34.** The superimpose Fourier Transform method applied to spectroscopy and imaging according to claim 27, wherein said the superimposed peak shape should further include in the above step S3:
Select appropriate sampling points and resolution to group sample frequencies $\omega_0$ for the imaging signal of nuclear magnetic resonance, perform peak superimpose with the superimpose functions for the absorption, dispersion or magnitude peak shapes of the Fourier Transform in each group.

**35.** The superimpose Fourier Transform method applied to spectroscopy and imaging according to claim 27, wherein said the superimposed peak shape should further include:
The harmonic nuclear magnetic resonance time signal *f(t)* is discretized and digitally sampled. If there are *N* of samples, it should have a set of discrete signal points *f(0), f(1), f(2), ···, f(k), ···, f(N-1)*. *N* of the data *F(0), F(1), F(2),*

$\cdots F(k), \cdots, F(N\text{-}1)$ are acquired by discrete Fourier Transform to get a following Fourier Transform matrix:

$$
\begin{pmatrix} F(0) \\ F(1) \\ F(2) \\ \vdots \\ F(k) \\ \vdots \\ F(N\text{-}1) \end{pmatrix}
=
\begin{pmatrix}
1 & 1 & 1 & \cdots & 1 \\
1 & W & W^2 & \cdots & W^{N-1} \\
1 & W^2 & W^4 & \cdots & W^{N-2} \\
\vdots & \vdots & \vdots & \ddots & \vdots \\
1 & W^k & W^{2k} & \cdots & W^{N-k} \\
\vdots & \vdots & \vdots & \ddots & \vdots \\
1 & W^{N-1} & W^{N-2} & \cdots & W
\end{pmatrix}
\begin{pmatrix} f(0) \\ f(1) \\ f(2) \\ \vdots \\ f(k) \\ \vdots \\ f(N\text{-}1) \end{pmatrix},
$$

where the factor $W = exp(-i2\pi/N)$ in the $N \times N$ of Fourier Transform matrix.

By inserting a specific diagonal superimpose matrix in above formula, a superimpose Fourier Transform matrix is obtained for superimpose operation:

$$
\begin{pmatrix} F(0) \\ F(1) \\ F(2) \\ \vdots \\ F(k) \\ \vdots \\ F(N\text{-}1) \end{pmatrix}
=
\begin{pmatrix}
1 & 1 & 1 & 1 & \cdots & 1 \\
1 & W & W^2 & W^3 & \cdots & W^{N-1} \\
1 & W^2 & W^4 & W^6 & \cdots & W^{N-2} \\
\vdots & \vdots & \vdots & \vdots & \ddots & \vdots \\
1 & W^k & W^{2k} & W^{3k} & \cdots & W^{N-k} \\
\vdots & \vdots & \vdots & \vdots & \ddots & \vdots \\
1 & W^{N-1} & W^{N-2} & W^{N-3} & \cdots & W
\end{pmatrix}
\begin{pmatrix}
2(0) & 0 & 0 & 0 & \cdots & 0 \\
0 & 2(0) & 0 & 0 & \cdots & 0 \\
0 & 0 & 2(0) & 0 & \cdots & 0 \\
\vdots & \vdots & \vdots & \vdots & \ddots & \vdots \\
0 & 0 & 0 & 0 & \cdots & 0 \\
\vdots & \vdots & \vdots & \vdots & \ddots & \vdots \\
0 & 0 & 0 & 0 & \cdots & 2(0)
\end{pmatrix}
\begin{pmatrix} f(0) \\ f(1) \\ f(2) \\ \vdots \\ f(k) \\ \vdots \\ f(N\text{-}1) \end{pmatrix}.
$$

36. The superimpose Fourier Transform method applied to spectroscopy and imaging according to claim 35, wherein was **characterized by** determining value of 2 or 0 in the diagonal matrix elements as per row-to-row or desired resolution $\Delta N$ in the imaging region.

37. The superimpose Fourier Transform method applied to spectroscopy and imaging according to claim 36, wherein was characterized to set sampling points according to computer binary system. Take arrangement mode of 2, 0, 2, 0,$\cdots\cdots$ in the diagonal matrix elements to execute left-superimpose operation of the peak shapes;

$$
\begin{pmatrix}
2 & 0 & 0 & 0 & 0 & \cdots & 0 \\
0 & 0 & 0 & 0 & 0 & \cdots & 0 \\
0 & 0 & 2 & 0 & 0 & \cdots & 0 \\
0 & 0 & 0 & 0 & \vdots & \ddots & \vdots \\
0 & 0 & 0 & 0 & 2 & \cdots & 0 \\
\vdots & \vdots & \vdots & \vdots & \vdots & \ddots & \vdots \\
0 & 0 & 0 & 0 & 0 & \cdots & 0
\end{pmatrix},
$$

Take arrangement mode of 0, 2, 0, 2,$\cdots\cdots$ in the diagonal matrix elements to execute right-superimpose operation of the peak shapes,

$$\begin{pmatrix} 0 & 0 & 0 & 0 & 0 & \cdots & 0 \\ 0 & 2 & 0 & 0 & 0 & \cdots & 0 \\ 0 & 0 & 0 & 0 & 0 & \cdots & 0 \\ 0 & 0 & 0 & 2 & \vdots & \ddots & \vdots \\ 0 & 0 & 0 & 0 & 0 & \cdots & 0 \\ \vdots & \vdots & \vdots & \vdots & \vdots & \ddots & \vdots \\ 0 & 0 & 0 & 0 & 0 & \cdots & 2 \end{pmatrix}.$$

38. The superimpose Fourier Transform method applied to spectroscopy and imaging according to claim 27, wherein said the superimposed peak shape should further include: adjacent harmonic signals can be superimposed for the front peak by left or right superimpose and for the back peak by right or left superimpose synchronously in the above step S3.

39. The superimpose Fourier Transform method applied to spectroscopy and imaging according to claim 27, wherein is applicable to imaging techniques by echo detection including ultrasonic imaging, radar imaging, sonar imaging and digital imaging.

40. The superimpose Fourier Transform method applied to spectroscopy and imaging according to any item in claims 27 to 39, wherein was characterized to handle the signals with free induction decay and phase shift. The free induction decay and phase shift are in exponential forms Therefore, these exponential components are actually equivalent to apodization functions multiplied to the signals. Their expressions of the corresponding peak shapes remain symmetric superimpose.

Figure 1

Figure 2

Figure 3

Figure 4

Figure 5

Figure 6

Figure 7

Figure 8

Figure 9

Figure 10

Figure 11

Figure 12

Figure 13

Figure 14

Figure 15

Figure 16

Figure 17

Figure 18

Figure 19

Figure 20

Figure 21

Figure 22

Figure 23

Figure 24

Figure 25

Figure 26

Figure 27

Figure 28

Figure 29

Figure 30

Figure 31

Figure 32

Figure 33

Figure 34

Figure 35

EP 3 594 709 A1

Figure 36

Figure 37

61

Figure 38

| | |
|---|---|
| **11**<br>$K_{11}[\cos(\omega_{11}t)+i\ \sin(\omega_{11}t)]$ | **12**<br>$K_{12}[\cos(\omega_{12}t)+i\ \sin(\omega_{12}t)]$ |
| **21**<br>$K_{21}[\cos(\omega_{21}t)+i\ \sin(\omega_{21}t)]$ | **22**<br>$K_{22}[\cos(\omega_{22}t)+i\ \sin(\omega_{22}t)]$ |

Figure 39

$\omega_{11}$     $\omega_{12}$

Figure 40

Figure 41

Figure 42

Figure 43

Figure 44

Figure 45

Figure 46

Figure 47

## INTERNATIONAL SEARCH REPORT

International application No.

**PCT/CN2018/076387**

### A. CLASSIFICATION OF SUBJECT MATTER

G01R 33/46(2006.01)i; G01R 33/48(2006.01)i; G01R 33/56(2006.01)i; G01N 21/35(2014.01)i

According to International Patent Classification (IPC) or to both national classification and IPC

### B. FIELDS SEARCHED

Minimum documentation searched (classification system followed by classification symbols)

G01R G01N

Documentation searched other than minimum documentation to the extent that such documents are included in the fields searched

Electronic data base consulted during the international search (name of data base and, where practicable, search terms used)

CNABS; CNTXT; VEN; EPTXT; TWABS; CNKI; 万方, WANFAGN; 百度学术, BAIDU SCHOLAR: 福建加谱新科科技有限公司, 陈舒平, 光谱, 傅里叶, 变换, 叠加, 干涉, 成像, 红外, 重构, 核磁共振, 离散化, Fourier, transform, spectrum, add, overlap, interference, imaging, IR, infrared, reconstruction, MRI, magnetic resonance imaging

### C. DOCUMENTS CONSIDERED TO BE RELEVANT

| Category* | Citation of document, with indication, where appropriate, of the relevant passages | Relevant to claim No. |
|---|---|---|
| PX | CN 107655845 A (FUJIAN JIAPU XINKE TECHNOLOGY CO., LTD.) 02 February 2018 (2018-02-02)<br>　　claims 1-11, description, paragraphs [0076]-[0150], and figures 1-16 | 1-14 |
| PX | CN 107656223 A (FUJIAN JIAPU XINKE TECHNOLOGY CO., LTD.) 02 February 2018 (2018-02-02)<br>　　claims 1-10, description, paragraphs [0089]-[0161], and figures 1-15 | 15-26 |
| PX | CN 107728089 A (FUJIAN JIAPU XINKE TECHNOLOGY CO., LTD.) 23 February 2018 (2018-02-23)<br>　　claims 1-10, description, paragraphs [0094]-[0173], and figures 1-16 | 27-40 |
| A | CN 1598505 A (XI'AN INSTITUTE OF OPTICS AND PRECISION MECHANICS, CAS) 23 March 2005 (2005-03-23)<br>　　description, page 2, line 15 to page 3, line 6, and figure 1 | 1-40 |
| A | CN 101133316 A (MKS INSTRUMENTS, INC.) 27 February 2008 (2008-02-27)<br>　　description, page 7, line 30 to page 16, line 2, and figures 1-7 | 1-40 |

☐ Further documents are listed in the continuation of Box C.　　☑ See patent family annex.

| | |
|---|---|
| *　　Special categories of cited documents:<br>"A"　document defining the general state of the art which is not considered to be of particular relevance<br>"E"　earlier application or patent but published on or after the international filing date<br>"L"　document which may throw doubts on priority claim(s) or which is cited to establish the publication date of another citation or other special reason (as specified)<br>"O"　document referring to an oral disclosure, use, exhibition or other means<br>"P"　document published prior to the international filing date but later than the priority date claimed | "T"　later document published after the international filing date or priority date and not in conflict with the application but cited to understand the principle or theory underlying the invention<br>"X"　document of particular relevance; the claimed invention cannot be considered novel or cannot be considered to involve an inventive step when the document is taken alone<br>"Y"　document of particular relevance; the claimed invention cannot be considered to involve an inventive step when the document is combined with one or more other such documents, such combination being obvious to a person skilled in the art<br>"&"　document member of the same patent family |

| Date of the actual completion of the international search | Date of mailing of the international search report |
|---|---|
| **13 April 2018** | **08 June 2018** |

| Name and mailing address of the ISA/CN | Authorized officer |
|---|---|
| **State Intellectual Property Office of the P. R. China**<br>**No. 6, Xitucheng Road, Jimenqiao Haidian District, Beijing**<br>**100088**<br>**China** | |
| Facsimile No. **(86-10)62019451** | Telephone No. |

Form PCT/ISA/210 (second sheet) (January 2015)

| INTERNATIONAL SEARCH REPORT | International application No. |
|---|---|
| Information on patent family members | **PCT/CN2018/076387** |

| Patent document cited in search report | | | Publication date (day/month/year) | Patent family member(s) | | | Publication date (day/month/year) |
|---|---|---|---|---|---|---|---|
| CN | 107655845 | A | 02 February 2018 | None | | | |
| CN | 107656223 | A | 02 February 2018 | None | | | |
| CN | 107728089 | A | 23 February 2018 | None | | | |
| CN | 1598505 | A | 23 March 2005 | CN | 100385213 | C | 30 April 2008 |
| CN | 101133316 | A | 27 February 2008 | US | 7546208 | B2 | 09 June 2009 |
| | | | | US | 2006241491 | A1 | 26 October 2006 |
| | | | | EP | 1856506 | A1 | 21 November 2007 |
| | | | | TW | 200639379 | A | 16 November 2006 |
| | | | | KR | 20070121653 | A | 27 December 2007 |
| | | | | SG | 134853 | B | 30 October 2009 |
| | | | | WO | 2006096530 | A1 | 14 September 2006 |
| | | | | JP | 2008532052 | A | 14 August 2008 |
| | | | | SG | 134853 | A1 | 28 September 2007 |

Form PCT/ISA/210 (patent family annex) (January 2015)

**REFERENCES CITED IN THE DESCRIPTION**

**Patent documents cited in the description**

- CN 201710908925X
- CN 201710910214
- CN 201710908949
- US 4307343 A